(19) Europäisches Patentamt
European Patent Office
Office européen des brevets

(11) **EP 2 756 110 B1**

(12) **EUROPÄISCHE PATENTSCHRIFT**

(45) Veröffentlichungstag und Bekanntmachung des Hinweises auf die Patenterteilung:
**08.03.2017 Patentblatt 2017/10**

(51) Int Cl.:
*C23C 16/40* *(2006.01)*    *C23C 16/56* *(2006.01)*
*C23C 28/04* *(2006.01)*

(21) Anmeldenummer: **12761964.1**

(22) Anmeldetag: **17.09.2012**

(86) Internationale Anmeldenummer:
**PCT/EP2012/068204**

(87) Internationale Veröffentlichungsnummer:
**WO 2013/037997 (21.03.2013 Gazette 2013/12)**

(54) **SCHNEIDEINSATZ UND VERFAHREN ZU DESSEN HERSTELLUNG**

CUTTING INSERT AND METHOD FOR PRODUCTION THEREOF

ORGANE DE COUPE ET SON PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.09.2011 DE 102011053705**

(43) Veröffentlichungstag der Anmeldung:
**23.07.2014 Patentblatt 2014/30**

(73) Patentinhaber: **Walter AG**
**72072 Tübingen (DE)**

(72) Erfinder:
• **STIENS, Dirk**
**72076 Tübingen (DE)**
• **RUPPI, Sakari**
**8500-308 Portimao (PT)**
• **FUHRMANN, Thomas**
**91207 Lauf (DE)**

(74) Vertreter: **WSL Patentanwälte Partnerschaft mbB**
**Kaiser-Friedrich-Ring 98**
**65185 Wiesbaden (DE)**

(56) Entgegenhaltungen:
**EP-A2- 1 905 870    WO-A1-2009/101025**

**Beschreibung**

GEGENSTAND DER ERFINDUNG

Die Erfindung betrifft einen beschichteten Schneideinsatz aus einem Hartmetall-, Cermet-, oder Keramik-Substratkörper und einer darauf mittels CVD-Verfahren aufgebrachten mehrlagigen Beschichtung, welche ausgehend von der Substratoberfläche eine oder mehrere Hartstofflagen, über den Hartstofflagen eine alpha-Aluminiumoxid ($\alpha$-$Al_2O_3$) - Lage und optional wenigstens abschnittsweise über der $\alpha$-$Al_2O_3$-Lage eine oder mehrere weitere Hartstofflagen als Dekor- oder Verschleißerkennungslagen aufweist.

HINTERGRUND DER ERFINDUNG

Schneideinsätze für die Werkstoffbearbeitung, insbesondere für die zerspanende Metallbearbeitung, bestehen aus einem Hartmetall-, Cermet-, oder Keramiksubstratkörper, der in den meisten Fällen zur Verbesserung der Schneid- und/oder Verschleißeigenschaften mit einer ein- oder mehrlagigen Oberflächenbeschichtung versehen ist. Die Oberflächenbeschichtungen bestehen aus übereinander angeordneten Hartstofflagen aus Carbiden, Nitriden, Oxiden, Carbonitriden, Oxinitriden, Oxicarbiden, Oxicarbonitriden, Boriden, Boronitriden, Borocarbiden, Borocarbonitriden, Borooxinitriden, Borooxocarbiden oder Borooxocarbonitriden der Elemente der Gruppen IVa bis VIIa des Periodensystems und/oder des Aluminiums, gemischtmetallischen Phasen sowie Phasengemischen der vorgenannten Verbindungen. Beispiele für die vorgenannten Verbindungen sind TiN, TiC, TiCN und $Al_2O_3$. Ein Beispiel für eine gemischtmetallische Phase, bei der in einem Kristall ein Metall teilweise durch ein anderes ersetzt ist, ist TiAlN. Beschichtungen der vorgenannten Art werden durch CVD-Verfahren (chemische Dampfphasenabscheidung), PCVD-Verfahren (Plasma-unterstützte CVD-Verfahren) oder durch PVD-Verfahren (physikalische Dampfphasenabscheidung) aufgebracht.

In nahezu jedem Material herrschen Eigenspannungen infolge von mechanischer, thermischer und/oder chemischer Behandlung. Bei der Herstellung von Schneideinsätzen durch Beschichten eines Substratkörpers mittels CVD-Verfahren resultieren Eigenspannungen beispielsweise zwischen der Beschichtung und dem Substrat und zwischen den einzelnen Lagen der Beschichtung aus den unterschiedlichen Wärmeausdehnungskoeffizienten der Materialien. Die Eigenspannungen können Zugeigenspannungen oder Druckeigenspannungen sein. Beim Aufbringen einer Beschichtung mittels PVD-Verfahren werden zusätzliche Spannungen durch den Ionenbeschuss bei diesem Verfahren in die Beschichtung eingebracht. In mittels PVD-Verfahren aufgebrachten Beschichtungen herrschen in der Regel Druckeigenspannungen vor, wogegen CVD-Verfahren üblicherweise Zugeigenspannungen in der Beschichtung erzeugen.

Die Wirkung der Eigenspannungen in der Beschichtung und im Substratkörper können ohne erheblichen Einfluss auf die Eigenschaften des Schneideinsatzes sein, sie können aber auch erhebliche vorteilhafte oder nachteilige Auswirkungen auf die Verschleißbeständigkeit des Schneideinsatzes haben. Zugeigenspannungen, welche die Dehngrenze des jeweiligen Materials übersteigen, verursachen Brüche und Risse in der Beschichtung senkrecht zur Richtung der Zugeigenspannung. Im Allgemeinen ist ein gewisses Maß an Druckeigenspannung in der Beschichtung erwünscht, da dadurch Oberflächenrisse verhindert oder geschlossen und die Ermüdungseigenschaften der Beschichtung und damit des Schneideinsatzes verbessert werden. Zu hohe Druckeigenspannungen können jedoch zu Haftungsproblemen und Abplatzen der Beschichtung führen.

Es gibt 3 Arten von Eigenspannungen: Makrospannungen, die über makroskopische Bereiche des Materials nahezu homogen verteilt sind, Mikrospannungen, die in mikroskopischen Bereichen, wie beispielsweise einem Korn, homogen sind, und inhomogene Mikrospannungen, die auch auf einer mikroskopischen Ebene inhomogen sind. Aus praktischer Sicht und für die mechanischen Eigenschaften eines Schneideinsatzes sind die Makrospannungen von besonderer Bedeutung.

Eigenspannungen werden üblicherweise in der Einheit Megapascal (MPa) angegeben, wobei Zugeigenspannungen ein positives Vorzeichen (+) und Druckeigenspannungen ein negatives Vorzeichen (-) aufweisen.

Es ist bekannt, dass Hartmetallschneidwerkzeuge, die mit Hartstoffschichten wie beispielsweise TiN, TiC, TiCN, TiAlN, $Al_2O_3$ oder Kombinationen davon beschichtet sind, hervorragende Verschleißbeständigkeit aufweisen können, jedoch können sie bei thermomechanischer Wechselbeanspruchung in unterbrochenen Schneidoperationen, wie sie beispielsweise beim Kurbelwellenfräsen auftritt, aufgrund eines Verlustes an Zähigkeit gegenüber unbeschichteten Schneidwerkzeugen oder solchen, die mittels PVD-Verfahren beschichtet sind, eher ausfallen. Ähnliches gilt für die Drehbearbeitung im unterbrochenen Schnitt oder unter ungünstigen Schnittbedingungen (z. B. durch Maschine oder Werkstück-Spannung bedingte Vibrationen). Für solche Anwendungen unter ungünstigen Bedingungen werden bisher CVD-Beschichtungen mit begrenzter Schichtdicke (selten mehr als 10 $\mu$m) eingesetzt, da die unter anderem durch Zugspannungen bedingte Versprödung des Schneidstoffs mit der Dicke der CVD-Beschichtung zunimmt. Hoch verschleißfeste Schneidstoffsorten haben dagegen häufig Schichtdicken von 20 $\mu$m oder mehr, können aber nur im kontinuierlichen Schnitt unter günstigen Bedingungen eingesetzt werden. Bei Schneideinsätzen zur Drehbearbeitung von Stahl oder Guss sind also sowohl eine hohe Verschleißfestigkeit als auch eine hohe Zähigkeit erwünscht, zwei Eigenschaften, die häufig nicht gleichzeitig erzielt werden können.

Die DE-A-197 19 195 beschreibt einen Schneideinsatz mit einer mehrlagigen Beschichtung, die in einem kontinuierlichen CVD-Verfahren bei Temperaturen zwischen 900°C und 1100°C abgeschieden wird. Der Wechsel des Materials in der mehrlagigen Beschichtung von einer zur nächsten Lage erfolgt durch eine Veränderung der Gaszusammensetzung in dem CVD-Verfahren. Die äußerste Schicht (Deckschicht) besteht aus einer ein- oder mehrphasigen Schicht aus Carbiden, Nitriden oder Carbonitriden von Zr oder Hf, in der innere Druckeigenspannungen vorherrschen. Die darunter liegenden Schichten bestehen aus TiN, TiC oder TiCN und weisen ausnahmslos innere Zugeigenspannungen auf. Die in der äußeren Schicht gemessene Druckeigenspannung liegt zwischen -500 und -2.500 MPa. Hierdurch soll die Bruchzähigkeit verbessert werden.

Zur Erhöhung der Druckeigenspannungen in der Beschichtung des Substratkörpers von Schneideinsätzen oder anderen Werkzeugen ist es bekannt, diese einer mechanischen Oberflächenbehandlung zu unterziehen. Bekannte mechanische Behandlungsverfahren sind das Bürsten und die Strahlbehandlung. Bei der Strahlbehandlung wird ein feinkörniges Strahlmittel mit Korngrößen bis etwa 600 $\mu$m mittels Pressluft unter erhöhtem Druck auf die Oberfläche der Beschichtung gerichtet. Eine solche Oberflächenbehandlung kann in der äußersten Schicht sowie auch den darunter liegenden Schichten Zugeigenspannungen vermindern oder Druckeigenspannungen erhöhen. Bei der Strahlbehandlung unterscheidet man zwischen Trockenstrahlbehandlung, bei der das feinkörnige Strahlmittel in trockenem Zustand eingesetzt wird, und Nassstrahlbehandlung, bei der das körnige Strahlmittel in einer Flüssigkeit suspendiert vorliegt.

Es wurde festgestellt, dass die Auswahl des Strahlmittels einen erheblichen Einfluss auf die Veränderungen der Eigenspannungen in der Beschichtung und in dem Substrat des Schneideinsatzes hat, insbesondere die Härte des Strahlmittels im Verhältnis zur Härte und Dicke der Beschichtung. Es konnte gezeigt werden, dass bei Verwendung eines Strahlmittels, dessen Härte größer als die Härte der äußersten Schicht der Beschichtung ist, der Verschleißmechanismus beim Strahlen Abrasion ist und hohe Druckspannungen nur an den nahen Oberflächenbereichen der Schicht bis ca. 1 $\mu$m Eindringtiefe entstehen, die sehr schnell wieder relaxieren. In tiefer liegenden Schichten oder im Substrat findet im Wesentlichen keine Erniedrigung der Zugspannungen oder Erhöhung der Druckspannungen statt. Die nach dem Beschichtungsprozeß vorherrschende Eigenspannung im Substrat bleibt unverändert. Eine Erhöhung der Zähigkeit des Werkzeugs kann nicht erreicht werden.

Ist die Härte des Strahlmittels gleich der Härte der äußersten Schicht der Beschichtung, so ist der Verschleißmechanismus beim Strahlen Oberflächenzerrüttung und es entstehen hohe Druckspannungen die sich bis in tiefere Schichtlagen und abhängig von der Schichtdicke auch bis ins Substrat auswirken können. Bei dicken Schichten (>>10 $\mu$m) kann beim Nassstrahlen die Spannung im Substrat nur wenig verändert und die Zugfähigkeit erhöht werden. Will man trotzdem die Druckspannung im Substrat auch bei dicken Schichten erhöhen, so muss man sehr lange Trockenstrahlen, was zu einer Erhöhung der Störungen im Gitter führt und Haftungsprobleme der Beschichtung verursachen kann.

Ist die Härte des Strahlmittels kleiner als die Härte der äußersten Schicht der Beschichtung, wird als Verschleißmechanismus dieser äußersten Schicht ebenfalls im Wesentlichen Oberflächenzerrüttung (shot peening) angenommen. Die Verschleißrate an der äußersten Beschichtung ist geringer, so dass längere Strahlzeiten ohne nennenswerten Abtrag der Schicht möglich sind. Ein weiterer Vorteil ist, dass dabei keine oder nur geringe Störungsgrade in die obersten Lagen der Beschichtung eingebaut werden. Je nach Wahl der Verfahrensparameter (unter anderem Strahlmittel, -druck, -dauer und -winkel) und Schichtdicke können Eigenspannungs-Änderungen in unterschiedlichen Tiefen des Verbundes aus Hartmetall und Beschichtung erreicht werden. D.h. als Ergebnis der Strahlbehandlung können Druckspannungen in unterschiedlichen Lagen der Beschichtung oder auch im Substrat vorliegen.

Die DE-A-101 23 554 beschreibt ein Strahlverfahren unter Verwendung eines körnigen Strahlmittels mit maximalem Durchmesser von 150 $\mu$m. Dadurch wird in der äußersten Schicht und den darunter liegenden, vorzugsweise bis in den oberflächennahen Bereich des Substrats hinein, eine Absenkung von Zugeigenspannungen oder Erhöhung von Druckspannungen erreicht. In der obersten Schicht werden vorzugsweise Druckspannungen von einigen GPa erreicht.

Die Schrift WO2009/101025 lehrt Verfahren zum Herstellen eines beschichteten Schneideinsatzes, wobei nach der Beschichtung eine Strahlbehandlung so durchzuführen ist, dass die größte Veränderung der Druckeigenspannung in der Beschichtung einen Betrag zwischen 10 MPa und 1000 MPa aufweist, und dass das Verhältnis der Beträge der größten Veränderung der Eigenspannung in der Beschichtung zur größten Veränderung der Eigenspannung im Substrat kleiner 2 ist.

Schneideinsätze mit einer äußeren Verschleißschutzschicht aus Alpha- oder Gamma-Aluminiumoxid für die Metallbearbeitung sind seit vielen Jahren im Einsatz und werden in der Literatur ausführlich beschrieben. Es hat sich gezeigt, dass Alpha-Aluminiumoxid-Beschichtungen mit bestimmten Vorzugsorientierungen des Kristallwachstums bei der Abscheidung im PVD- oder CVD-Verfahren besondere Vorteile, insbesondere verbessertes Verschleißverhalten, haben können, wobei für unterschiedliche Anwendungen des Schneideinsatzes auch unterschiedliche Vorzugsorientierungen der Aluminiumoxidschicht besonders vorteilhaft sein können. Die Vorzugsorientierung des Wachstums wird in der Regel in Bezug auf die über die Miller-Indizes definierten Ebenen, z. B. die (001)-Ebene, des Kristallgitters angegeben und als Textur oder Fasertextur bezeichnet und über einen sog. Texturkoeffizienten (TC) definiert. Beispielsweise sollen Schneideinsätze mit einer Verschleißschicht aus Alpha-Aluminiumoxid mit (001)-Textur gegenüber anderen Vorzugsorientierungen Vorteile bei der Stahlbearbeitung hinsichtlich Freiflächen- und Kolkverschleiß sowie plastischer Verformung haben.

Die US-A-2007/0104945 beschreibt Schneidwerkzeuge mit $\alpha$-Al$_2$O$_3$-Verschleißschichten mit (001)-Textur und kolumnarer Mikrostruktur. Diese Vorzugsorientierung zeigt sich durch hohe Intensitäten des (006)-Peaks im Röntgenbeugungsspektrum (XRD-Diffraktogramm) und wird erreicht, indem sowohl die Keimbildung als auch das Wachstum der $\alpha$-Al$_2$O$_3$-Schicht im CVD-Verfahren unter bestimmten Bedingungen durchgeführt werden. Die Keimbildung erfolgt bei $\leq$ 1000°C auf einer TiAlCNO-Anbindungsschicht durch ein mehrstufiges Verfahren, bei dem die Substrate nacheinander definierten Gaskonzentrationen von TiCl$_4$ und AlCl$_3$, Spülschritten unter N$_2$ und definierten H$_2$O-Konzentrationen ausgesetzt werden. Anschließend wird die Keimbildung von $\alpha$-Al$_2$O$_3$ durch Wachstum ohne katalytische Zusätze fortgesetzt, und schließlich findet bei 950 bis 1000°C das Schichtwachstum zur gewünschten Schichtdicke unter definiertem Konzentrationsverhältnis von CO/CO$_2$ und in Anwesenheit typischer Katalysatoren, wie H$_2$S, SO$_2$ oder SF$_6$, in Konzentrationen $\leq$ 1 Vol.-% statt.

Die EP 1 953 258 beschreibt ebenfalls Schneidwerkzeuge mit $\alpha$-Al$_2$O$_3$-Verschleißschichten mit (001)-Textur auf Hartmetallsubstraten mit einer mit Co-Binder angereicherter Randzone. Die Vorzugsorientierung der $\alpha$-Al$_2$O$_3$-Verschleißschicht wird durch eine Keimbildung analog der US-A-2007/0104945 erreicht, allerdings wird davon abweichend beim weiteren Wachstum der Schicht das Verhältnis CO/CO$_2$ allmählich erhöht.

Die EP-A-2 014 789 beschreibt ebenfalls Schneidwerkzeuge mit $\alpha$-Al$_2$O$_3$-Verschleißschichten mit (001)-Textur auf Hartmetallsubstraten mit einer mit Co-Binder angereicherter Randzone, die sich besonders zur Zerspanung von Stahl bei hohen Schnittgeschwindigkeiten, insbesondere zum Stahldrehen, eignen sollen.

AUFGABE DER ERFINDUNG

Die Aufgabe der vorliegenden Erfindungen bestand in der Bereitstellung von Schneideinsätzen für die spanende Metallbearbeitung, insbesondere die Drehbearbeitung von Stahl- oder Gusswerkstoffen, die eine gegenüber dem Stand der Technik verbesserte Verschleißbeständigkeit aufweisen, insbesondere erhöhte Beständigkeit zugleich gegen Verschleißformen, die bei kontinuierlicher Beanspruchung auftreten, wie Freiflächenverschleiß, Kolkverschleiß und plastische Verformung, als auch gegen Verschleißformen, die bei thermomechanischer Wechselbeanspruchung auftreten, wie Ausbrüche, Bruch und Kammrisse, und die somit einem breiteren Anwendungsbereich bieten als bekannte Schneideinsätze.

BESCHREIBUNG DER ERFINDUNG

Gelöst wird diese Aufgabe durch einen Schneideinsatz aus einem Hartmetall-, Cermet-, oder Keramik-Substratkörper und einer darauf mittels CVD-Verfahren aufgebrachten mehrlagigen Beschichtung mit einer Gesamtschichtdicke von 5 bis 40 $\mu$m, welche ausgehend von der Substratoberfläche eine oder mehrere Hartstofflagen, über den Hartstofflagen eine alpha-Aluminiumoxid ($\alpha$-Al$_2$O$_3$) - Lage mit einer Lagendicke von 3 bis 20 $\mu$m und optional wenigstens abschnittsweise über der $\alpha$-Al$_2$O$_3$-Lage eine oder mehrere weitere Hartstofflagen als Dekor- oder Verschleißerkennungslagen aufweist, wobei
die $\alpha$-Al$_2$O$_3$-Lage eine kristallographische Vorzugsorientierung aufweist, charakterisiert durch einen Texturkoeffizienten TC (0 0 12) $\geq$ 5 für die (0 0 12) Wachstumsrichtung mit

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

wobei

I(hkl) die durch Röntgenbeugung gemessenen Intensitäten der Beugungsreflexe sind,
I$_0$(hkl) die Standardintensitäten der Beugungsreflexe nach pdf-Karte 42-1468 sind,
n die Anzahl der für die Berechnung verwendeten Reflexe ist und

für die Berechnung von TC(0 0 12) folgende Reflexe verwendet werden:
(0 1 2), (1 0 4), (1 1 0), (1 1 3), (1 1 6), (3 0 0) und (0 0 12), welche gemäß pdf-Karte 42-1468 folgende Standardintensitäten I$_0$(hkl) besitzen:

| Reflex (h k l): | Standardintensität $I_0$(hkl): |
|---|---|
| (0 1 2) | 70 |
| (1 0 4) | 97 |
| (1 1 0) | 42 |
| (1 1 3) | 100 |
| (1 1 6) | 82 |
| (3 0 0) | 45 |
| (0 0 12) | 2 |

und wobei die $\alpha$-$Al_2O_3$-Lage eine Eigenspannung im Bereich von 0 bis +300 MPa aufweist und das Substrat innerhalb eines Bereichs von 0 bis 10 $\mu$m von der Substratoberfläche ein Eigenspannungs-Minimum im Bereich von -2000 bis -400 MPa aufweist.

Es wurde überraschenderweise gefunden, dass man bei einem Schneideinsatz mit einer Beschichtung der hierin beschriebenen Art bei der spanenden Metallbearbeitung, insbesondere bei der Drehbearbeitung von Stahl- oder Gusswerkstoffen, eine gegenüber bekannten Schneideinsätzen verbesserte Verschleißbeständigkeit und einem breiteren Anwendungsbereich erzielen kann, wenn die als Verschleißschicht dienende harte $\alpha$-$Al_2O_3$-Lage eine kristallographische Vorzugsorientierung mit einem Texturkoeffizienten TC (0 0 12) $\geq$ 5 und gleichzeitig eine niedrige Zugeigenspannung im Bereich von 0 bis +300 MPa oder sogar eine Druckeigenspannung aufweist und gleichzeitig das Substrat in einer Zone, die von der Substratoberfläche bis zu einer Eindringtiefe von 10 $\mu$m reicht und als "nahe Interface-Substrat-Zone" des Substratkörpers bezeichnet wird, eine Druckeigenspannung im Bereich von -2000 bis -400 MPa aufweist.

Die erfindungsgemäße Kombination aus der kristallographischen Vorzugsorientierung der $Al_2O_3$-Lage und den definierten Parametern der Eigenspannungen der $Al_2O_3$-Lage und des Substratkörpers in der nahen Interface-Substrat-Zone liefert Schneideinsätze, sich dadurch auszeichnen, dass sie sowohl eine erhöhte Beständigkeit gegen Verschleißformen, die bei kontinuierlicher Beanspruchung auftreten, wie Freiflächenverschleiß, Kolkverschleiß und plastische Verformung, als auch gegen Verschleißformen, die bei thermomechanischer Wechselbeanspruchung auftreten, wie Ausbrüche, Bruch und Kammrisse. Demgegenüber sind bekannte Schneideinsätze in der Regel für eine bestimmte Beanspruchungsart ausgelegt und optimiert und besitzen daher häufig einen begrenzten und sehr spezifischen Anwendungsbereich. Der erfindungsgemäße Schneideinsatz besitzt hingegen aufgrund seiner erhöhten Beständigkeit gegen verschiedene Verschleißformen, nämlich solchen, die überwiegend bei kontinuierlicher Beanspruchung auftreten, und solchen, die überwiegend bei thermomechanischer Wechselbeanspruchung auftreten, einen breiteren Anwendungsbereich als bekannte Schneideinsätze.

In einer bevorzugten Ausführungsform des erfindungsgemäßen Schneideinsatzes umfasst die Herstellung des Schneideinsatzes, dass man das Substrat nach dem Aufbringen der mehrlagigen Beschichtung einer Trocken- oder Nassstrahlbehandlung, vorzugsweise einer Trockenstrahlbehandlung, unter Verwendung eines körnigen Strahlmittels unterzieht, wobei das Strahlmittel vorzugsweise eine geringere Härte als Korund ($\alpha$-$Al_2O_3$) aufweist.

Die erfindungsgemäßen Eigenspannungen in der $Al_2O_3$-Lage und im Substratkörper des Schneideinsatzes lassen sich mit Vorteil dadurch erzielen, dass man den Schneideinsatz nach dem Aufbringen der mehrlagigen Beschichtung auf das Substrat einer Trocken- oder Nassstrahlbehandlung unter Verwendung eines körnigen, Strahlmittels unterzieht. Dabei sollte das Strahlmittel eine geringere Härte als Korund ($\alpha$-$Al_2O_3$) aufweisen, insbesondere wenn die mehrlagige Beschichtung eine große Dicke besitzt. Beispielsweise eignen sich als Strahlmittel Partikel aus Stahl, Glas oder Zirkoniumdioxid ($ZrO_2$). Die Strahlbehandlung wird zweckmäßigerweise bei einem Strahlmitteldruck von 1 bar bis 10 bar durchgeführt. Die Verwendung eines Strahlmittels, das eine geringere Härte als Korund hat, im vorgenannten Druckbereich hat den Vorteil, dass dabei keine oder nur geringe Störungsgrade in die obersten Lagen der Beschichtung eingebaut werden. Die $\alpha$-$Al_2O_3$-Lage und die darunter angeordneten Lagen der Beschichtung zeigen nur wenig Veränderung in ihren Eigenspannungen.

Besonders bevorzugt ist die Trockenstrahlbehandlung, da sie einen gleichmäßigeren Eintrag des Strahldrucks in die Beschichtung und den Substratkörper über die gesamte Oberfläche gewährleistet als die Nassstrahlbehandlung. Bei der Nassstrahlbehandlung dämpft die Bildung eines Flüssigkeitsfilms auf der bestrahlten Oberfläche den Eintrag von Eigenspannungen gegenüber der Trockenstrahlbehandlung bei vergleichbaren Strahldruckbedingungen erheblich ab. Dadurch besteht die Gefahr, dass der Eintrag des Strahldrucks an den Kanten des Werkzeugs, d. h. auch an den wichtigen Schneidkanten, erheblich höher ist als auf den glatten Oberflächen, was dazu führen kann, dass die Kanten unter dem Strahldruck beschädigt werden, bevor es überhaupt zu einem wesentlichen oder zumindest ausreichenden Eintrag auf den für Schneidvorgänge wesentlichen Flächen des Werkzeugs, insbesondere der Spanfläche, kommt.

Mittels Trockenstrahlbehandlung sind auch höhere Drücke über einen langen Zeitraum möglich, ohne dass das Werkzeug hierdurch beschädigt wird.

Die für das Einbringen bzw. Einstellen der erfindungsgemäßen Eigenspannungen in die $\alpha$-Al$_2$O$_3$-Lage und den Substratkörper erforderliche Dauer der Strahlbehandlung und der erforderliche Strahldruck sind Parameter, die der Fachmann innerhalb der hierin definierten Grenzen durch einfache Experimente an ungestrahlten Schneideinsätzen ermitteln kann. Eine pauschale Angabe ist hier nicht möglich, da die sich einstellenden Eigenspannungen nicht nur von der Dauer der Strahlbehandlung und dem Strahldruck abhängen, sondern auch von dem Aufbau und der Dicke der Gesamtbeschichtung und auch von der Zusammensetzung und Struktur des Substrats. Allerdings hat der Strahldruck dabei im Vergleich zur Strahldauer den wesentlich größeren Einfluss auf die Veränderung der Eigenspannungen in der Beschichtung und dem Substratkörper. Die Dauer der Strahlbehandlung darf nicht zu kurz sein, damit die gewünschten Veränderungen der Eigenspannungen bis in den Substratkörper vordringen und sich die erfindungsgemäßen Eigenspannungswerte einstellen können. Die optimale Dauer der Strahlbehandlung hängt auch von der hierfür verwendeten Anlage, dem Abstand, der Art und der Ausrichtung der Strahldüsen und von der Bewegung der Strahldüsen über dem bestrahlten Werkzeug ab. Für die Herstellung des erfindungsgemäßen Schneideinsatzes geeignete Strahlbehandlungsdauern liegen im Bereich von 10 bis 600 Sekunden, sie können aber auch im Bereich von 15 bis 60 Sekunden liegen. Insbesondere wenn durch die Strahlbehandlung zunächst eine oder mehrere Lagen über der $\alpha$-Al$_2$O$_3$-Lage abgetragen werden sollen, ist eine längere Strahlbehandlungsdauer zweckmäßig oder erforderlich. Geeignete Strahlmitteldrücke liegen im Bereich von 1 bis 10 bar, vorzugsweise 2 bar bis 8 bar, besonders bevorzugt 3 bar bis 5 bar. Die Erfindung ist jedoch nicht auf die vorgenannten Strahlbehandlungsdauern und Strahlmitteldrücke beschränkt.

Das Strahlmittel kann beispielsweise Stahl, Glas oder ZrO$_2$ sein. Die erfindungsgemässen Eigenspannungszustände können mit jedem der genannten oder anderen geeigneten Strahlmitteln eingestellt werden. Der Fachmann kann in Kenntnis der Erfindung ein nach verfahrens- oder anlagentechnischen oder tribologischen Gesichtspunkten günstiges Medium auswählen und durch einfache Versuche geeignete Strahlparameter finden. Vorzugsweise besteht das Strahlmittel aus kugelförmigen Partikeln. Die mittlere Korngröße des Strahlmittels liegt zweckmäßigerweise im Bereich von 20 bis 450 $\mu$m, vorzugsweise 40 bis 200 $\mu$m, besonders bevorzugt 50 bis 100 $\mu$m, sie hat jedoch keinen wesentlichen Einfluss auf die Erzeugung von Druckeigenspannungen in dem Substratkörper. Jedoch beeinflusst die mittlere Korngröße des Strahlmittels die Oberflächenrauheit der äußersten Schicht der Beschichtung. Eine geringe mittlere Korngröße (feine Körnung) liefert bei der Bestrahlung eine glatte Oberfläche, wogegen eine hohe mittlere Korngröße eine rauhe Oberfläche ergibt. Für die erfindungsgemäße Werkzeuge ist die Erzeugung einer glatten Oberfläche und somit die Verwendung eines Strahlmittels mit geringer mittlerer Korngröße bevorzugt. Die Vickers-Härten der vorgenannten Strahlmittel liegen etwa im Bereich von 500 bis 1500. Al$_2$O$_3$ (Korund) ist erfindungsgemäß als Strahlmittel in der Regel nicht geeignet.

Der Strahlwinkel, d. h. der Winkel zwischen dem Behandlungsstrahl und der Oberfläche des Werkzeugs, hat ebenfalls einen wesentlichen Einfluss auf den Eintrag von Druckeigenspannungen. Bei einem Strahlwinkel von 90° erfolgt der maximale Eintrag von Druckeigenspannungen. Geringere Strahlwinkel, d. h. schräges Einstrahlen des Strahlmittels, führen zu einer stärkeren Abrasion der Oberfläche und geringerem Druckeigenspannungseintrag. Die stärkste Abrasionswirkung wird bei Einstrahlwinkeln von etwa 15° bis 40° erzielt. Bei geringeren Strahlwinkeln kann es erforderlich sein, einen höheren Strahldruck und/oder eine längere Strahldauer zu wählen, um einen Eintrag von Druckeigenspannungen zu erzielen, der dem Eintrag bei einem Strahlwinkel von 90° entspricht, bei dem auch die hierin beschriebenen Beispiele durchgeführt wurden. In Kenntnis der Erfindung kann der Fachmann jedoch diese bei geringeren Strahlwinkeln anzuwendenden Parameter leicht ermitteln.

Der Begriff "oberflächennaher Bereich" des Substratkörpers bezeichnet einen Bereich von der äußersten Oberfläche des Substratkörpers bis zu einer Eindringtiefe von maximal 1 bis 2 $\mu$m in Richtung des Inneren des Substratkörpers. Die zerstörungsfreie und phasenselektive Analyse von Eigenspannungen erfolgt mittels Röntgendiffraktionsverfahren. Die weitverbreitet angewendete winkeldispersive Messung nach dem sin$^2\psi$-Verfahren liefert einen Mittelwert für den Eigenspannungsanteil in einer Ebene und erlaubt in WC-Substraten Eigenspannungsmessungen nur bis zu sehr geringen Eindringtiefen von maximal 1 bis 2 $\mu$m von der Oberfläche aus, d. h. nur im "oberflächennahen Bereich" des Substratkörpers.

Der Begriff "nahe Interface-Substrat-Zone" des Substratkörpers bezeichnet einen Bereich von der äußersten Oberfläche des Substratkörpers bis zu einer Eindringtiefe von etwa 10 $\mu$m in Richtung des Inneren des Substratkörpers. Analysen des Eigenspannungsverlaufs in der "nahen Interface-Substrat-Zone" waren mit der bisher angewendeten Methode der winkeldispersiven Messung mit konventionellen Laborquellen nicht möglich. Zum einen ist die Eindringtiefe der winkeldispersiven Messung wie oben erwähnt auf eine nur sehr geringe Distanz von der äußersten Oberfläche des Substratkörpers begrenzt. Darüber hinaus liefert die winkeldispersive Messung nach dem sin$^2\psi$-Verfahren nur einen Mittelwert in einer Ebene, weshalb sich mit dieser Methode stufenweise Veränderungen oder Gradientenverläufe der Eigenspannungen innerhalb kurzer Distanzen mit dieser Methode nicht messen lassen. Für die Analyse der Eigenspannungen in der "nahen Interface-Substrat-Zone" des Substratkörpers bis zu einer Eindringtiefe von etwa 10 $\mu$m wurde daher für die gattungsgemäßen Schneideinsätze eine energiedispersive Messung angewendet, die die Analyse von Eigenspannungsverläufen bis zu einer Eindringtiefe von etwa 10 $\mu$m unter Erfassung der Veränderung der Eigenspannungen innerhalb dieses Bereichs erlaubt.

Die Beschichtung des erfindungsgemäßen Schneideinsatzes besteht aus einer Abfolge verschiedener Einzellagen. Diese unterschiedlichen Lagen besitzen bereits vor der Strahlbehandlung aufgrund ihrer unterschiedlichen Zusammensetzungen, Herstellungsbedingungen und Positionen innerhalb der Beschichtung in der Regel auch unterschiedliche Eigenspannungen, d. h. Zug- oder Druckspannungen unterschiedlicher Größen. Durch die Strahlbehandlung verändern sich die Eigenspannungen in den einzelnen Lagen wiederum aufgrund ihrer unterschiedlichen Zusammensetzungen, Herstellungsbedingungen und Positionen innerhalb der Beschichtung unterschiedlich stark. Entsprechendes gilt auch für das Substrat, wo die Eigenspannungen und Veränderungen der Eigenspannungen in unterschiedlichen Tiefen von der Oberfläche aus auch unterschiedlich groß sein können. Die Messung der Eigenspannungen ist erfindungsgemäß auf einen Bereich von der Substratoberfläche bis zu einer Eindringtiefe von 10 $\mu$m begrenzt. In WC-Substraten ist eine Messung der Eigenspannungen in viel größeren Tiefen technisch nicht möglich.

In einer bevorzugten Ausführungsform der Erfindung bestehen die über der Substratoberfläche und unter der $\alpha$-Al$_2$O$_3$-Lage angeordneten Hartstofflagen und die optional über der $\alpha$-Al$_2$O$_3$-Lage wenigstens abschnittsweise angeordneten Hartstofflagen aus Carbiden, Nitriden, Oxiden, Carbonitriden, Oxinitriden, Oxicarbiden, Oxicarbonitriden, Boriden, Boronitriden, Borocarbiden, Borocarbonitriden, Borooxinitriden, Borooxocarbiden, Borooxocarbonitriden der Elemente der Gruppen IVa bis VIIa des Periodensystems und/oder des Aluminiums und/oder gemischtmetallischen Phasen und/oder Phasengemischen der vorgenannten Verbindungen.

In einer weiteren bevorzugten Ausführungsform der Erfindung bestehen die über der Substratoberfläche und unter der $\alpha$-Al$_2$O$_3$-Lage angeordneten Hartstofflagen aus TiN, TiCN und/oder TiAlCNO bestehen, wobei die Hartstofflagen jeweils Schichtdicken im Bereich von 0,1 $\mu$m bis 15 $\mu$m aufweisen.

Insbesondere die Lage aus TiAlCNO eignet sich als Anbindungslage unmittelbar unter der $\alpha$-Al$_2$O$_3$-Lage. Wenn unmittelbar unter der $\alpha$-Al$_2$O$_3$-Lage eine Hartstofflage aus TiAlCNO angeordnet ist, weist diese vorzugsweise eine Schichtdicke im Bereich von 0,1 $\mu$m bis 1 $\mu$m auf. Die TiAlCNO-Lage verbessert die Haftung der $\alpha$-Al$_2$O$_3$-Lage und fördert das Wachstum des Aluminiumoxids in der Alpha-Modifikation und mit der erfindungsgemäßen Vorzugsorientierung. Aufgrund ihrer Zusammensetzung und Mikrostruktur liefert sie eine hervorragende Anbindung an die TiCN-Schicht. Eine gute Anbindung der Schichten untereinander ist wichtig, um hohe Drücke bei der Strahlbehandlung anwenden zu können, ohne dass die Schichten abplatzen.

Hartstofflagen aus TiN oder TiCN, wenn eine oder mehrere davon vorhanden sind, weisen vorzugsweise Schichtdicken im Bereich von 2 $\mu$m bis 15 $\mu$m, besonders bevorzugt im Bereich von 3 $\mu$m bis 10 $\mu$m auf.

Vorzugsweise ist unter der Anbindungslage aus TiAlCNO und unter der $\alpha$-Al$_2$O$_3$-Lage eine TiCN-Lage angeordnet,, die zweckmäßigerweise die vorgenannte Schichtdicke im Bereich von 2 $\mu$m bis 15 $\mu$m, vorzugsweise im Bereich von 3 $\mu$m bis 10 $\mu$m aufweist. Die TiCN-Schicht wird vorzugsweise im Hochtemperatur-CVD-Verfahren (HT-CVD) oder im Medium-Temperatur-CVD-Verfahren (MT-CVD) aufgebracht, wobei das MT-CVD-Verfahren für die Herstellung von Zerspanwerkzeugen bevorzugt ist, da es kolumnare Schichtstrukturen liefert und aufgrund der niedrigeren Abscheidungstemeperatur Zähigkeitsverluste im Substrat vermindert.

In einer weiteren bevorzugten Ausführungsform der Erfindung weisen die über der Substratoberfläche und unter der $\alpha$-Al$_2$O$_3$-Lage angeordneten Hartstofflagen Lagen aus TiN, TiCN und/oder TiAlCNO zusammen eine Gesamtschichtdicke im Bereich von 3 $\mu$m bis 16 $\mu$m, vorzugsweise im Bereich von 5 $\mu$m bis 12 $\mu$m, besonders bevorzugt im Bereich von 7 $\mu$m bis 11 $\mu$m auf.

In einer weiteren bevorzugten Ausführungsform der Erfindung weist die mehrlagige Beschichtung ausgehend von der Substratoberfläche folgende Lagenabfolge auf: TiN - TiCN - TiAlCNO - $\alpha$-Al$_2$O$_3$, wobei optional wenigstens abschnittsweise über der $\alpha$-Al$_2$O$_3$-Lage eine TiN-Lage, eine TiC-Lage, eine TiCN-Lage oder eine Kombination daraus vorgesehen sind.

Der erfindungsgemäße Schneideinsatz kann wenigstens abschnittsweise über der $\alpha$-Al$_2$O$_3$-Lage eine oder mehrere weitere Hartstofflagen aufweisen, vorzugsweise eine TiN-Lage, eine TiC-Lage, eine TiCN-Lage oder eine Kombination daraus. Solche Lagen werden häufig als Dekor- und/oder Verschleißerkennungslagen auf das schwarz erscheinende $\alpha$-Al$_2$O$_3$ aufgebracht und besitzen selbst eine gelbgoldene oder grausilberne Farbe und können als Indikator für eine Benutzung des Werkzeugs dienen, da diese Lagen bei der Metallbearbeitung abgetragen werden. Üblicherweise sind solche Dekor- und/oder Verschleißerkennungslagen nicht auf solchen Flächen des Werkzeugs aufgebracht bzw. werden nach der Abscheidung auf dem gesamten Werkzeugkörper von solchen Flächen wieder entfernt, die bei der Metallbearbeitung direkt mit dem Metall in Kontakt treten, z. B. den Spanflächen, da sie je nach Bearbeitungsverfahren und Werkstückmaterial nachteilige Auswirkungen auf die Bearbeitung haben können. Üblicherweise werden die Dekor- und/oder Verschleißerkennungslagen von den entsprechenden Flächen durch Strahl- oder Bürstbehandlung abrasiv abgetragen. Eine solche abrasive Entfernung der dünnen oder weichen Dekorschichten kann einen Eintrag von Druckeigenspannungen in die verbleibende $\alpha$-Al$_2$O$_3$-Lage bewirken, allerdings nur in oberflächennahen Bereichen von < 1 $\mu$m Eindringtiefe, so dass keine signifikante Veränderung des erfindungsgemäßen Eigenspannungszustands der $\alpha$-Al$_2$O$_3$-Schicht entsteht. Aufgrund der geringen Schwächung von Röntgenstrahlung durch $\alpha$-Al$_2$O$_3$ ist

dieser oberflächennahe Bereich durch röntgenographische Eigenspannungsmessung messtechnisch ohnehin kaum oder nur durch Extrapolation zugänglich. Bei den hier verwendeten Messparametern des $\sin^2\psi$-Verfahrens und Kippwinkeln bis $\psi = 89{,}5°$ stammt die ermittelte Eigenspannung der $\alpha$-Al$_2$O$_3$-Lage aus einer Informationstiefe von ca. $\geq 1{,}5\,\mu m$.

Zur Einstellung des erfindungsgemäßen Eigenspannungszustands im Schneidwerkzeug wird eine Strahlbehandlung mit einem Strahlmittel angewendet, dessen Härte vorzugsweise kleiner als die Härte der $\alpha$-Al$_2$O$_3$-Lage ist. Es wird dann als Verschleißmechanismus, der auf die $\alpha$-Al$_2$O$_3$-Lage wirkt, im Wesentlichen Oberflächenzerrüttung (shot peening) angenommen. Es erfolgt kein wesentlicher Abtrag der $\alpha$-Al$_2$O$_3$-Lage und es werden durch diesen Mechanismus und dieses Verfahren hohe Druckeigenspannungen in dem Substratkörper erzeugt, selbst wenn die Gesamtschichtdicke der Beschichtung bis zu 40 $\mu m$ groß ist.

Die Gesamtschichtdicke der Beschichtung beträgt wenigstens 5 $\mu m$, bevorzugt wenigstens 10 $\mu m$, besonders bevorzugt wenigstens 15 $\mu m$. Eine zu geringe Gesamtschichtdicke der Beschichtung hat den Nachteil, dass kein ausreichender Verschleißschutz durch die Beschichtung mehr gewährleistet ist.

In einer weiteren bevorzugten Ausführungsform der Erfindung besteht der Substratkörper aus Hartmetall, vorzugsweise enthaltend 4 bis 12 Gew.-% Co, Fe und/oder Ni, vorzugsweise Co, optional 0,5 bis 10 Gew.-% kubische Carbide der Metalle der Gruppen IVb, Vb und VIb des Periodensystems, vorzugsweise Ti, Nb, Ta oder Kombinationen davon, und als Rest WC.

In einer weiteren Ausführungsform der Erfindung besteht der Substratkörper aus Hartmetall der vorgenannten Zusammensetzung und weist eine gegenüber der nominellen Gesamtzusammensetzung des Substratkörpers mit Co-Binderphase angereicherte und von kubischen Carbiden abgereicherte Oberflächenzone auf, die ausgehend von der Substratoberfläche eine Dicke von 5 $\mu m$ bis 30 $\mu m$, vorzugsweise von 10 $\mu m$ bis 25 $\mu m$ besitzt, wobei der Gehalt an Co in der mit Co-Binderphase angereicherten Oberflächenzone wenigstens 1,5-mal höher ist als im Kern des Substrats und der Gehalt an kubischen Carbiden in der mit Co-Binderphase angereicherten Oberflächenzone höchstens das 0,5-fache des Gehalts an kubischen Carbiden im Kern des Substrats beträgt.

Das Vorsehen einer mit Co-Binderphase angereicherten Oberflächenzone in dem Hartmetallsubstrat verbessert die Zähigkeit des Substratkörpers und eröffnet einen breiteren Anwendungsbereich des Werkzeugs, wobei Hartmetallsubstrate mit einer mit Co-Binderphase angereicherten Oberflächenzone vorzugsweise für Schneidwerkzeuge für die Bearbeitung von Stahl eingesetzt werden, wogegen Schneidwerkzeuge für die Bearbeitung von Gusseisen vorzugsweise ohne eine solche mit Co-Binderphase angereicherte Oberflächenzone hergestellt werden.

Die vorliegende Erfindung umfasst auch ein Verfahren zur Herstellung des hierin beschriebenen erfindungsgemäßen Schneideinsatzes, bei dem man

auf einen Substratkörper aus Hartmetall-, Cermet-, oder Keramik mittels CVD-Verfahren eine mehrlagige Beschichtung mit einer Gesamtschichtdicke von 5 bis 40 $\mu m$ aufbringt, welche ausgehend von der Substratoberfläche eine oder mehrere Hartstofflagen, über den Hartstofflagen eine alpha-Aluminiumoxid ($\alpha$-Al$_2$O$_3$) - Lage mit einer Lagendicke von 1 bis 20 $\mu m$ und optional wenigstens abschnittsweise über der $\alpha$-Al$_2$O$_3$-Lage eine oder mehrere weitere Hartstofflagen als Dekor- oder Verschleißerkennungslagen aufweist, wobei die Abscheidungsbedingungen für die $\alpha$-Al$_2$O$_3$-Lage so gewählt werden, dass die $\alpha$-Al$_2$O$_3$-Lage eine kristallographische Vorzugsorientierung aufweist, charakterisiert durch einen Texturkoeffizienten TC (0 0 12) $\geq 5$ für die (0 0 12) Wachstumsrichtung mit

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

wobei

I(hkl) die durch Röntgenbeugung gemessenen Intensitäten der Beugungsreflexe sind,
I$_0$(hkl) die Standardintensitäten der Beugungsreflexe nach pdf-Karte 42-1468 sind,
n die Anzahl der für die Berechnung verwendeten Reflexe ist und

für die Berechnung von TC(0 0 12) folgende Reflexe verwendet werden:
(0 1 2), (1 0 4), (1 1 0), (1 1 3), (1 1 6), (3 0 0) und (0 0 12), welche gemäß pdf-Karte 42-1468 folgende Standardintensitäten I$_0$(hkl) besitzen:

| Reflex (h k l): | Standardintensität I$_0$(hkl): |
|---|---|
| (0 1 2) | 70 |
| (1 0 4) | 97 |

(fortgesetzt)

| Reflex (h k l): | Standardintensität $I_0$(hkl): |
|---|---|
| (1 1 0) | 42 |
| (1 1 3) | 100 |
| (1 1 6) | 82 |
| (3 0 0) | 45 |
| (0 0 12) | 2 |

und man das Substrat nach dem Aufbringen der mehrlagigen Beschichtung einer Trocken- oder Nassstrahlbehandlung, vorzugsweise einer Trockenstrahlbehandlung, unter Verwendung eines körnigen Strahlmittels unterzieht, wobei das Strahlmittel vorzugsweise eine geringere Härte als Korund ($\alpha$-Al$_2$O$_3$) aufweist und wobei man den Strahldruck, die Strahldauer und den Strahlwinkel der Strahlbehandlung so auswählt, dass die $\alpha$-Al$_2$O$_3$-Lage nach der Strahlbehandlung eine Eigenspannung im Bereich von 0 bis +300 MPa aufweist und das Substrat nach der Strahlbehandlung innerhalb eines Bereichs von 0 bis 10 $\mu$m von der Substratoberfläche ein Eigenspannungs-Minimum im Bereich von -2000 bis -400 MPa aufweist.

MESSVERFAHREN

Die zerstörungsfreie und phasenselektive Analyse von Eigenspannungen ist nur durch Röntgendiffraktionsverfahren möglich (siehe zum Beispiel V. Hauk. Structural and Residual Stress Analysis by Nondestructive Methods. Elsevier, Amsterdam, 1997"). Das weitverbreitet angewendete sin$^2\psi$-Verfahren (E. Macherauch, P. Müller, Z. angew. Physik 13 (1961), 305) für die Röntgenanalyse von Eigenspannungen beruht auf der Annahme eines homogenen Spannungszustandes innerhalb der Eindringtiefe des Röntgenstrahles und liefert nur einen Mittelwert für den Spannungsanteil in einer Ebene. Daher ist das sin$^2\psi$-Verfahren nicht für die Untersuchung von mehrlagigen, strahlbehandelten CVD-Systemen geeignet, in denen innerhalb kurzer Distanzen steile oder stufenweise Veränderungen der Eigenspannung erwartet werden. Stattdessen werden in solchen Fällen weiterentwickelte Verfahren wie z.B. das "Universal Plot-Verfahren" angewendet, die auch in dünnen Schichten die Erfassung von Eigenspannungsgradienten erlauben (Ch. Genzel in: E.J. Mittemeijer, P. Scardi (Herausg.) Diffraction Analysis of the Microstructure of Materials. Springer Series in Material Science, Band 68 (2004), S. 473; Ch. Genzel, Mat. Science and Technol. 21 (2005), 10). Da die erfindungsgemäßen Eigenspannungen mit Vorteil durch eine Trockenstrahl-Behandlung unter Verwendung eines Strahlmittels erzielt werden, dessen Härte geringer als diejenige des Korunds ($\alpha$-Al$_2$O$_3$) ist, werden in der $\alpha$-Al$_2$O$_3$-Lage keine oder nur sehr geringe Störungsgrade und nur eine geringe Veränderung der Eigenspannung herbeigeführt. Optional über der $\alpha$-Al$_2$O$_3$-Lage angeordnete Dekor- oder Verschleißerkennungslagen werden durch abrasiv wirkende Verfahren entfernt, die ihrerseits den Eigenspannungszustand in der verbleibenden $\alpha$-Al$_2$O$_3$-Lage nur in den nahen Oberflächenbereichen der Schicht bis ca. 1 $\mu$m Eindringtiefe verändern. Bei den hier verwendeten Messparametern stammt das Messsignal der $\alpha$-Al$_2$O$_3$-Lage aus einer Informationstiefe von ca. $\geq$ 1,5 $\mu$m. Da die Messdaten keinen Hinweis auf starke Eigenspannungstiefengradienten in der $\alpha$-Al$_2$O$_3$-Lage lieferten, wurden diese nach dem sin$^2\psi$-Verfahren ausgewertet.
Die Eigenspannungen der Schichten wurden in dem winkeldispersiven Diffraktionsmodus auf einem GE Inspection Technologies (vormals Seifert), 5-Circle-Diffraktometer ETA (Ch. Genzel, Adv. X-Ray Analysis, 44 (2001), 247.) durchgeführt. Die für die Messungen und die Bestimmung der Eigenspannungen angewendeten Parameter sind in der nachstehenden Tabelle 1 zusammengefasst.
Die zerstörungsfreie Analyse der Eigenspannungsverteilung im Bereich der Grenzfläche zwischen dem Substratkörper und der Beschichtung ist nur durch Hochenergie-Röntgendiffraktion unter Verwendung intensiver paralleler Synchrotronstrahlung möglich. Um den Einfluss des Strahlverfahrens auf den Zustand der Eigenspannung in der Nähe der Substratoberfläche zu ermitteln, wurde energiedispersive Diffraktion angewendet. Dabei wurde das "modifizierte Multi-Wellenlängen-Verfahren" (wie es in C. Stock, Promotionsarbeit, TU Berlin, 2003; Ch. Genzel, C. Strock, W. Reimers, Mat. Sci. Eng., A 372 (2004), 28, beschrieben ist) benutzt, welches das Tiefenprofil der Eigenspannungen in dem Substrat bis zu einer vom Substratmaterial abhängigen Eindringtiefe liefert. Bei WC-Co-Substraten beträgt diese Eindringtiefe etwa 10 $\mu$m. Die Experimente wurden auf dem Materialforschungsmessplatz EDDI (Energy Dispersive Diffraction) durchgeführt, welche von dem Helmholtz-Zentrum Berlin für Materialien und Energie GmbH auf dem Synchrotron-Speicherring BESSY betrieben wird (Ch. Genzel, I. A. Denks, M. Klaus, Mat. Sci. Forum 524-525 (2006), 193). Die entsprechenden experimentellen Parameter sind in Tabelle 2 angegeben.

**Tabelle 1: Experimentelle Parameter für die Eigenspannungsanalyse der Beschichtung**

| Strahlung | CuKα (ohne Kβ-Filter) 40 kV / 45 mA (Langfeinfokus) |
|---|---|
| Diffraktionsmodus | winkeldispersiv |
| Optische Elemente | • Primärstrahl: polykapillare Halblinse<br>• Gebeugter Strahl: Parallelstrahloptik<br>(0,4° Soller-Blende+ 001-LiF Monochromator) |
| Reflexionen | $Al_2O_3$: 116 (2θ = 57,5°)<br>Messbereich in 2θ: 56,0° ≤ 2θ ≤ 59,0°; Δ2θ = 0,05° |
| ψ-Bereich | 0° ...89.5° ($\sin^2\psi$ = 0 ... 0,99996)<br>Schrittweite für 0 ≤ ψ ≤ 80°: $\Delta\sin^2\psi$ = 0,05°; für ψ > 80°: Δψ = 0,5° |
| Messdauer | 15s / Stufe in Δ2θ (0,05°) |
| Beugungslinienauswertung | Pearson VII-Funktion für die $K\alpha_1$- und $K\alpha_2$-Linien |
| Lineare Absorptionskoeffizienten | $\mu_{Al2O3}$ = 124 cm$^{-1}$ |
| Elastische Diffraktionskonstanten (DEC)[*)] | $Al_2O_3$: $s_1$(116) = -0,474 x 10$^{-6}$ MPa$^{-1}$<br>½ $s_2$ (024) = 2,83 x 10$^{-6}$ MPa$^{-1}$ |

[*)] Berechnet anhand der Einkristall-Elastizitätskonstanten von $Al_2O_3$ (Landoldt-Börnstein, New Series, Group III, Band 11, Springer, Berlin, 1979) und TiN (W. Kress, P. Roedhammer, H. Bilz, W. Teuchert, A. N. Christensen. Phys. Rev. B17 (1978), 111.) nach dem Eshelby-Kröner-Modell (J. D. Eshelby. Proc. Roy. Soc. (London) A241 (1957), 376; E. Kröner, Z. Physik 151 (1958), 504.)

**Tabelle 2: Experimentelle Parameter für die Eigenspannungsanalyse in den Substratkörpern**

| Strahlung | weiße Synchrotronstrahlung, E = [10keV ... 120keV] |
|---|---|
| Diffraktionsmodus | energiedispersiv |
| Strahlquerschnitt | 0,25 x 0,25 mm$^2$ |
| Absorber | 2 cm Graphit |
| Optik im gebeugtem Strahl | Doppelspaltsystem mit einer Öffnung von 0,03 x 5 mm$^2$ |
| Diffraktionswinkel | 2θ = 11° |
| Detektor | Festkörper-LEGe-Detektor (Canberra) |
| Messmodus | symmetrischer ψ-Modus (Reflexion), ψ = 0° ... 89°,<br>Δψ = 4° für 0 ≤ ψ ≤ 70°<br>Δψ = 2° für 70° < ψ ≤ 80°<br>Δψ = 1° für 80° < ψ ≤ 89° |
| Messdauer | 60 s / Diffraktionsspektrum |
| ausgewertete Beugungslinien | 001,101, 110,002,201, 112 |
| Elastische Diffraktionskonstanten | entnommen aus B. Eigenmann, E. Macherauch, Mat.-Wiss. u. Werkstofftechn. 27 (1996), 426 |
| Kalibrierung | mit spannungsfreiem W-Pulver unter den gleichen experimentellen Bedingungen |

Die Texturmessungen wurden auf einem Diffraktometer XRD3003PTS der Firma GE Sensing and Inspection Technologies unter Verwendung von Cu $K_\alpha$-Strahlung durchgeführt. Die Röntgenröhre wurde bei 40 kV und 40 mA im Punktfokus betrieben. Primärseitig wurde eine Polykapillar-Halblinse mit einer Messöffnung mit fester Größe verwendet, wobei die bestrahlte Fläche der Probe so gewählt wurde, dass der Röntgenstrahl nur auf der beschichteten Fläche auftrifft. Sekundärseitig wurden ein Sollerspalt mit 0,4° Divergenz und ein 0,25 mm starker Ni $K_\beta$-Filter verwendet. Es

wurden in θ-2θ--Anordnung -Scans im Winkelbereich 20° < 2θ < 100° mit einer Schrittweite von 0,25° durchgeführt. Die Messungen wurden an einer flachen Oberfläche des beschichteten Schneideinsatzes durchgeführt, vorzugsweise an der Freifläche. Die Messungen wurden direkt an der Aluminiumoxidlage als äußerste Lage durchgeführt. Im Falle, dass über der zu vermessenden Aluminiumoxidlage eine weitere Lage vorhanden ist, so wird diese vor der Messung durch ein Verfahren entfernt, das die Messergebnisse nicht wesentlich beeinflusst, beispielsweise durch Ätzen. Zur Berechnung des Texturkoeffizienten TC(0 0 12) wurden die Peakhöhenintensitäten verwendet. Auf die gemessenen Rohdaten wurden Untergrundabzug und ein parabolischer Peakfit an 5 Messpunkten angewendet. Es wurden keine weiteren Korrekturen der Peakintensitäten, wie etwa $K_{\alpha 2}$-Stripping oder Dünnschichtkorrekturen, vorgenommen.

Die zum Einstellen des erfindungsgemäßen Eigenspannungszustands verwendete Strahlbehandlung erzeugt keine signifikante Veränderung von Integrallinienbreiten und Intensitäten der Beugungsreflexe. Die Auswirkungen abrasiv wirkender Nachbehandlungsverfahren, welche zur Entfernung von über der $\alpha$-Al$_2$O$_3$-Schicht angeordneten Decklagen angewendet werden, sind erfahrungsgemäß zwar gering, aber nicht ausgeschlossen. Deshalb ist die Messung der Textur bei den erfindungsgemäßen Schneideinsätzen an Flächen durchzuführen, die solchen Nachbehandlungsschritten nicht unterzogen wurden, beispielsweise an Freifläche des Schneideinsatzes.

Der Texturkoeffizient TC(0 0 12) ist wie folgt definiert:

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

wobei

I(hkl) die wie oben beschrieben durch Röntgenbeugung gemessenen und korrigierten Intensitäten der Beugungsreflexe sind,

$I_0$(hkl) die Standardintensitäten der Beugungsreflexe nach pdf-Karte 42-1468 sind,

n die Anzahl der für die Berechnung verwendeten Reflexe ist und

für die Berechnung von TC(0 0 12) folgende Reflexe verwendet werden:

(0 1 2), (1 0 4), (1 1 0), (1 1 3), (1 1 6), (3 0 0) und (0 0 12), welche gemäß pdf-Karte 42-1468 folgende Standardintensitäten $I_0$(hkl) besitzen:

| Reflex (h k l): | Standardintensität $I_0$(hkl): |
|---|---|
| (0 1 2) | 70 |
| (1 0 4) | 97 |
| (1 1 0) | 42 |
| (1 1 3) | 100 |
| (1 1 6) | 82 |
| (3 0 0) | 45 |
| (0 0 12) | 2 |

Die durch den Texturkoeffizienten TC(0 0 12) gegebene relative Intensität des (0 0 12)-Beugungsreflexes ist ein Maß für die (0 0 1)-Vorzugsorientierung bzw. Fasertextur der $\alpha$-Al$_2$O$_3$-Schicht. Alternativ zur Auswertung des (0 0 12)-Reflexes kann die Textur auch über den (0 0 6)-Beugungsreflex als TC(0 0 6) ausgewertet werden. Die Verwendung des (0 0 12)-Reflexes ist aber für die erfindungsgemäßen Beschichtungen zu bevorzugen, weil der (0 0 6)-Reflex des $\alpha$-Al$_2$O$_3$ nicht immer sicher vom häufig sehr intensiven (2 0 0)-Reflex des TiCN getrennt werden kann.

BEISPIELE

Beispiel 1

WC/Co-Hartmetallsubstratkörper (Wendeschneidplatten verschiedener Zusammensetzungen (HM1, HM2, HM3, HM4, HM5 und HM6) wurden im CVD-Verfahren der Schichtabfolge TiN - MT-TiCN - $\alpha$-Al$_2$O$_3$ - HT-TiCN mit verschiedenen Schichtdicken der einzelnen Lagen beschichtet. Zwischen der MT-TiCN-Schicht und der $\alpha$-Al$_2$O$_3$-Schicht wurde eine dünne (< 1 μm) Anbindungs- und Nukleationsschicht aus TiAlCNO abgeschieden. Alle Beschichtungen wurden in einem CVD-Reaktor vom Typ Bernex BPX325S mit radialer Gasströmung hergestellt.

Die MT-TiCN-Schicht wurde bei einem Druck von 90 mbar und folgenden Gaskonzentrationen abgeschieden (Prozentangaben in Bezug auf die Gase im CVD-Verfahren bedeuten Vol.-%): 2,0% $TiCl_4$, 0,5% $CH_3CN$, 10% $N_2$, 87,5% $H_2$.

Zwischen der MT-TiCN-Schicht und der $\alpha$-$Al_2O_3$-Schicht wurde eine dünne (< 1 $\mu$m) Anbindungs- und Nukleationsschicht in drei Prozessschritten abgeschieden.

1. Ti(C,N) - Dauer: 20 min, Temperatur: 1000°C, Druck: 500 mbar, Gaskonzentrationen: 5% $CH_4$, 2% $TiCl_4$, 25% $N_2$, Rest $H_2$

2. (Ti,Al)(C,N,O) - Dauer: 15 min, Temperatur: 1000°C, Druck: 75 mbar, Gaskonzentrationen: 5% CO, 1% $AlCl_3$, 2% $TiCl_4$, 25% $N_2$, Rest $H_2$

3. (Ti,Al)(C,N,O) - Dauer 5 min, Temperatur: 1000°C, Druck: 175 mbar, Gaskonzentrationen: 5% CO, 2,5% $CO_2$, 1% $AlCl_3$, 2% $TiCl_4$, 20% $N_2$, Rest $H_2$

Anschliessend wurde die $\alpha$-$Al_2O_3$-Schicht durch folgendes Verfahren nukleiert:

1. Spülen mit Ar, Dauer 5 min
2. Behandlung mit 2% $TiCl_4$, 2% $AlCl_3$, Rest $H_2$, bei T=1000°C, p = 175 mbar, Dauer 5 min
3. Spülen mit Ar, Dauer 5 min
4. Oxidation mit 2,5% $CO_2$, 12% CO, Rest $H_2$ bei T=1000°C, p = 175 mbar, Dauer 5 min
5. Spülen mit Ar, Dauer 5 min
6. Behandlung mit 2,5% $AlCl_3$, Rest $H_2$, bei T=1000°C, p = 175 mbar, Dauer 1 min

Zur weiteren Nukleation wurde eine dünne $\alpha$-$Al_2O_3$-Startschicht ohne Verwendung katalytischer Verbindungen unter folgenden Bedingungen abgeschieden:

T = 1010°C; p = 75 mbar; 2,5% $CO_2$; 2,0% HCl; 2,0% CO; 2,0% $AlCl_3$; Rest $H_2$, Dauer 40 min

Die Wachstumsbedingungen der erfindungsgemässen $\alpha$-$Al_2O_3$-Schicht wurden wie folgt gewählt:

T = 1010 °C, p = 85 mbar, Gaskonzentrationen: 91% $H_2$, 3,0% $CO_2$, 0,5% $H_2S$, 3,5% HCl, 2,5% $AlCl_3$. Alle Gaskomponenten wurden gleichzeitig in den angegebenen Konzentrationen eingeleitet.

Die erzeugten $\alpha$-$Al_2O_3$-Schichten hatten eine sehr hohe (0 0 1)-Vorzugsorientierung mit Texturkoeffizienten TC(0 0 12) > 5.

Als Referenz wurden Hartmetallsubstratkörper gleicher Zusammensetzung ebenfalls mit der Schichtabfolge TiN - MT-TiCN - $\alpha$-$Al_2O_3$ - HT-TiCN mit gleichen Schichtdicken der einzelnen Lagen beschichtet, wobei ebenfalls zwischen der MT-TiCN-Schicht und der $\alpha$-$Al_2O_3$-Schicht eine dünne (< 1 $\mu$m) Anbindungs- und Nukleationsschicht aus TiAlCNO abgeschieden wurde. Darauf wurde die $\alpha$-$Al_2O_3$-Schicht nach dem Stand der Technik nukleiert.

Die Wachstumsbedingungen der $\alpha$-$Al_2O_3$-Schicht nach dem Stand der Technik wurden wie folgt gewählt:

T = 1015 °C, p = 65 mbar, Gaskonzentrationen: 92,3% $H_2$, 3,5% $CO_2$, 0,2% $H_2S$, 2,0% HCl, 2,0% $AlCl_3$.

Die $\alpha$-$Al_2O_3$-Lagen nach dem Stand der Technik weisen nur eine moderate (0 0 1)-Vorzugsorientierung auf.

Die Zusammensetzungen der verwendeten Hartmetallsubstratkörper sind in Tabelle 3 angegeben. Die Schichtdicken der einzelnen Lagen und der für die $\alpha$-$Al_2O_3$-Lage bestimmte Texturkoeffizient TC(0 0 12) sind in Tabelle 4 angegeben.

**Tabelle 3: Hartmetalzzusammensetzungen**

| Hartmetall | Zusammensetzung (Gew.-%) | | | | Härte HV3 |
|---|---|---|---|---|---|
| | Co | WC | kubisches Metallcarbid | Sonst. | |
| HM1 | 7 | 86,5 | 5 | 0,5 | 1500 |
| HM2 | 7,5 | 87 | 5 | 0,5 | 1500 |
| HM3 | 6 | 94 | - | - | 1600 |
| HM4 | 5 | 86,5 | 8 | 0,5 | 1500 |

(fortgesetzt)

| Hartmetall | Zusammensetzung (Gew.-%) | | | | Härte HV3 |
|---|---|---|---|---|---|
| | Co | WC | kubisches Metallcarbid | Sonst. | |
| HM5 | 5,5 | 86 | 8 | 0,5 | 1550 |
| HM6 | 10 | 81 | 8,5 | 0,5 | 1300 |

**Tabelle 4:**

| Schichtsystem | | Schichtdicke [$\mu$m] | | | | | TC(0 0 12) |
|---|---|---|---|---|---|---|---|
| | | Gesamt | TiN | MT-TiCN | $\alpha$-Al$_2$O$_3$ | HT-TiCN | |
| Stand der Technik | a | 17 | 0,5 | 9 | 6 | 0,5 | 4,4 $\pm$ 0,7 |
| Stand der Technik | b | 20 | 0,5 | 9 | 9 | 0,5 | 4,5 $\pm$ 0,9 |
| Stand der Technik | c | 20 | 0,5 | 6 | 12 | 0,5 | 4,9 $\pm$ 0,4 |
| Stand der Technik | d | 10 | 0,5 | 4 | 4 | 0,5 | 2,5 $\pm$ 0,4 |
| Erfindungsgemäß | A | 17 | 0,5 | 9 | 6 | 0,5 | 6,0 $\pm$ 0,2 |
| Erfindungsgemäß | B | 20 | 0,5 | 9 | 9 | 0,5 | 6,1 $\pm$ 0,3 |
| Erfindungsgemäß | c | 20 | 0,5 | 6 | 12 | 0,5 | 6,2 $\pm$ 0,2 |
| Erfindungsgemäß | D | 10 | 0,5 | 4 | 4 | 0,5 | 5,5 $\pm$ 0,5 |

Die Texturkoeffizienten TC[0 0 12] sind angegeben als Mittelwerte von Messungen an $\geq$6 verschiedenen Schneideinsätzen aus mindestens 2 verschiedenen Beschichtungs-Chargen.

Die Schneidplatten wurden anschließend einer Strahlbehandlung unterzogen und die Eigenspannungen der $\alpha$-Al$_2$O$_3$-Lage sowie des Substratkörpers in der nahen Interface-Substrat-Zone (NISZ) gemessen. Die Ergebnisse sind in Tabelle 5 wiedergegeben. Der Wert "Eigenspannung NISZ Substrat" ist jeweils der Minimalwert innerhalb der gemessenen Eigenspannungs-Verläufe in der "nahen Interface-Substrat-Zone".

**Tabelle 5: Ergebnisse der Eigenspannungsmessungen an Schneideinsätzen**

| Schneideinsatz | Hartmetall | Schichtsystem | Strahlbehandlung | Eigenspannung $\alpha$-$Al_2O_3$ [MPa] | Eigenspannung TiCN [MPa] | Eigenspannung NISZ Substrat [MPa] |
|---|---|---|---|---|---|---|
| 1 (Stand der Technik) | HM1 | A | ungestrahlt | 136 | 598 | -350 |
| 2 (Erfindung) | HM1 | A | trocken / $ZrO_2$ / 5 bar / 120 sek | 96 | 255 | -600 |
| 3 (Stand der Technik) | HM3 | a | Ungestrahlt | 331 | 221 | -230 |
| 4 (Stand der Technik) | HM3 | a | trocken / $ZrO_2$ / 5 bar/ 120 sek | 197 | 323 | -625 |

**Tabelle 5 (Forts.): Ergebnisse der Eigenspannungsmessungen an Schneideinsätzen**

| Schneideinsatz | Hartmetall | Schichtsystem | Strahlbehandlung | Eigenspannung $\alpha$-Al2O3 [MPa] | Eigenspannung TiCN [MPa] | Eigenspannung NISZ Substrat [MPa] |
|---|---|---|---|---|---|---|
| 5 (Stand der Technik) | HM3 | A | ungestrahlt | 278 | 713 | -375 |
| 6 (Erfindung) | HM3 | A | trocken / $ZrO_2$ / 5 bar/ 120 sek | 206 | 478 | -510 |
| 7 (Stand der Technik) | HM5 | a | ungestrahlt | 256 | 330 | -290 |
| 8 (Stand der Technik) | HM5 | a | trocken / $ZrO_2$ / 5 bar/ 120 sek | 156 | 325 | -940 |
| 9 (Stand der Technik) | HM5 | A | ungestrahlt | 308 | 427 | -225 |
| 10 (Erfindung) | HM5 | A | trocken / $ZrO_2$ / 5 bar/ 120 sek | 135 | 396 | -860 |
| 11 (Stand der Technik) | HM6 | a | ungestrahlt | 369 | 612 | -380 |
| 12 (Stand der Technik) | HM6 | a | trocken / $ZrO_2$ / 5 bar/ 120 sek | 156 | 525 | -976 |
| 13 (Stand der Technik) | HM6 | A | ungestrahlt | 411 | 544 | -204 |
| 14 (Erfindung) | HM6 | A | trocken / $ZrO_2$ / 5 bar/ 120 sek | 147 | 257 | -1005 |
| 15 (Stand der Technik) | HM2 | b | ungestrahlt | 240 | 984 | -180 |
| 16 (Stand der Technik) | HM2 | b | trocken / $ZrO_2$ / 5 bar/ 120 sek | 98 | 595 | -580 |
| 17 (Stand der Technik) | HM2 | B | ungestrahlt | 224 | 1280 | -55 |
| 18 (Erfindung) | HM2 | B | trocken / $ZrO_2$ / 5 bar/ 120 sek | 22 | 654 | -620 |
| 19 (Stand der Technik) | HM4 | C | ungestrahlt | 191 | 1140 | -280 |
| 20 (Erfindung) | HM4 | C | trocken / $ZrO_2$ / 5 bar/ 120 sek | 77 | 733 | -720 |
| 21 (Stand der Technik) | HM2 | D | ungestrahlt | 435 | 870 | -180 |
| 22 (Erfindung) | HM2 | D | trocken / $ZrO_2$ / 5 bar/ 120 sek | 121 | -16 | -920 |

Beispiel 2 - Zerspanversuche

Mit den gemäß Beispiel 1 hergestellten Schneidplatten wurden Nockenwellen einer Außenbearbeitung im unterbrochenen Schnitt gemäß folgenden Versuchsparametern unterzogen:

| | | | |
|---|---|---|---|
| Werkstück: | Nockenwelle | | |
| Material: | 16MnCr5 ($R_m$=600-700N/mm$^2$) | | |
| Bearbeitung; | Längsdrehen im unterbrochenen Schnitt; Nassbearbeitung | | |
| Schnittdaten: | $V_c$ = 220 m/min | | |
| | f = 0,4 mm | | |
| | $a_p$ = 2,5 mm | | |
| Werkzeuggeometrie: | DNMG150608-NM4 | | |
| Standweg: | Stand der Technik: | Schneideinsatz 11 nach Tabelle 5: | 54 Bauteile |
| | Erfindung: | Schneideinsatz 14 nach Tabelle 5: | 80 Bauteile |

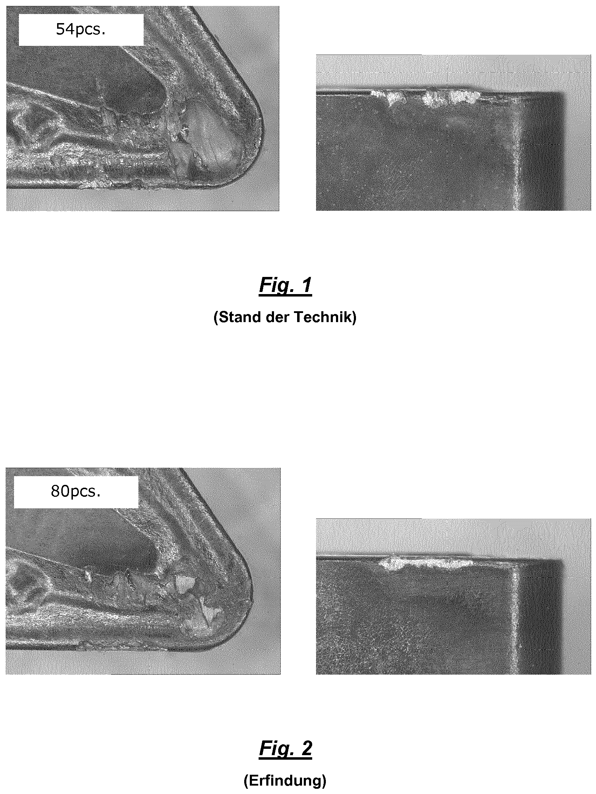

Figur 1 zeigt das Werkzeug nach dem Stand der Technik (Schneideinsatz 11 gemäß Tabelle 5) nach der Bearbeitung von 54 Bauteilen. Es sind nach Standzeitende sowohl Kolkverschleiß zu erkennen als auch Kerbverschleiß und Ausbrüche an der Schneidkante. Kolkverschleiß ist eine typische Verschleißform beim Drehen von Stahlwerkstoffen, die aufgrund mangelnder Verschleißfestigkeit bei hoher Schneidentemperatur durch thermische Überlastung des Werkzeugs entsteht. Die Kerben und Ausbrüche an der Schneidkante sind dagegen Anzeichen für eine unzureichende Zähigkeit des Werkzeugs unter den gewählten Arbeitsbedingungen.

Figur 2 zeigt den erfindungsgemäßen Schneideinsatz (Schneideinsatz 14 gemäß Tabelle 5) nach der Bearbeitung von 80 Bauteilen. Der Schneideinsatz hat deutlich weniger ausgeprägten Kolkverschleiß und keinen Kerben.

Beispiel 3 - Zerspanversuche

Gemäß Beispiel 1 hergestellte Schneidplatten wurden dem sogenannten Leistedrehtest (Test im stark unterbrochenen Schnitt) unterzogen. Bei diesem Test wird das Zähigkeitsverhalten von Wendeschneidplatten untersucht, indem eine mit vier Leisten aus Vergütungsstahl bestückte Welle in einem Außen-Längs-Drehprozess bearbeitet wird. Die Leisten, die hierbei zerspant werden, stellen nur einen Teil des Umfangs dar, so dass eine stark schlagende Wirkung auf die Werkzeugschneiden auftritt. Als Standweg des Werkzeugs wird die Anzahl der Eintritte in die Werkstücke bis zum Versagen der Schneide durch Bruch bestimmt (Schlagzahl).

| | |
|---|---|
| Material: | 42CrMo4; $R_m$ = 800 N/mm$^2$ |
| Bearbeitung; | Längsdrehen im unterbrochenen Schnitt; Trockenbearbeitung |
| Schnittdaten: | $V_c$ = 170 |
| | f = 0,32 mm |
| | $a_p$ = 2,5 mm |
| Werkzeuggeometrie: | CNMG120412-NM4 |
| Standweg / Schlagzahl (jeweils Mittelwert aus 6 getesteten Schneideinsätzen): | |
| Stand der Technik: | Schneideinsatz 15 gemäß Tabelle 5 497 Schläge |
| Erfindung: | Schneideinsatz 18 gemäß Tabelle 5 2946 Schläge |

Beispiel 4 - Zerspanversuche

Mit gemäß Beispiel 1 hergestellten Schneidplatten wurden Pumpengehäuse aus Kugelgraphitguss GGG50 einer Drehbearbeitung (Schruppen im unterbrochenen Schnitt) gemäß folgenden Versuchsparametern unterzogen:

| | |
|---|---|
| Werkstück: | Pumpengehäuse |
| Material: | GGG50 |
| Bearbeitung; | Drehen im unterbrochenen Schnitt; Trockenbearbeitung |
| Schnittdaten: | $V_c$ = 190 m/min |
| | f = 0,5 mm |
| | $a_p$ = 3,0 mm |

| Werkzeuggeometrie: | WNMA080412 | |
|---|---|---|
| Standweg: | Stand der Technik: | Schneideinsatz 3 gemäß Tabelle 5 70 Bauteile |
| | Erfindung: | Schneideinsatz 6 gemäß Tabelle 5 200 Bauteile |

**Patentansprüche**

1. Schneideinsatz aus einem Hartmetall-, Cermet-, oder Keramik-Substratkörper und einer darauf mittels CVD-Verfahren aufgebrachten mehrlagigen Beschichtung mit einer Gesamtschichtdicke von 5 bis 40 $\mu$m, welche ausgehend von der Substratoberfläche eine oder mehrere Hartstofflagen, über den Hartstofflagen eine alpha-Aluminiumoxid ($\alpha$-Al$_2$O$_3$) - Lage mit einer Lagendicke von 1 bis 20 $\mu$m und optional wenigstens abschnittsweise über der $\alpha$-Al$_2$O$_3$-Lage eine oder mehrere weitere Hartstofflagen als Dekor- oder Verschleißerkennungslagen aufweist, **dadurch gekennzeichnet, dass**
die $\alpha$-Al$_2$O$_3$-Lage eine kristallographische Vorzugsorientierung aufweist, charakterisiert durch einen Texturkoeffizienten TC (0 0 12) $\geq$ 5 für die (0 0 12) Wachstumsrichtung mit

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

wobei

I(hkl) die durch Röntgenbeugung gemessenen Intensitäten der Beugungsreflexe sind, I$_0$(hkl) die Standardintensitäten der Beugungsreflexe nach pdf-Karte 42-1468 sind,
n die Anzahl der für die Berechnung verwendeten Reflexe ist und
für die Berechnung von TC(0 0 12) folgende Reflexe verwendet werden:

(0 1 2), (1 0 4), (1 1 0), (1 1 3), (1 1 6), (3 0 0) und (0 0 12), welche gemäß pdf-Karte 42-1468 folgende Standardintensitäten I$_0$(hkl) besitzen:

| Reflex (h k l): | Standardintensität I$_0$(hkl): |
|---|---|
| (0 1 2) | 70 |
| (1 0 4) | 97 |
| (1 1 0) | 42 |
| (1 1 3) | 100 |
| (1 1 6) | 82 |
| (3 0 0) | 45 |
| (0 0 12) | 2 |

und wobei die $\alpha$-Al$_2$O$_3$-Lage eine Eigenspannung im Bereich von 0 bis +300 MPa aufweist und das Substrat innerhalb eines Bereichs von 0 bis 10 $\mu$m von der Substratoberfläche ein Eigenspannungs-Minimum im Bereich von -2000 bis -400 MPa aufweist.

2. Schneideinsatz nach Anspruch 1, **dadurch gekennzeichnet, dass** die Herstellung des Schneideinsatzes umfasst, dass man das Substrat nach dem Aufbringen der mehrlagigen Beschichtung einer Trocken- oder Nassstrahlbehandlung, vorzugsweise einer Trockenstrahlbehandlung, unter Verwendung eines körnigen Strahlmittels unterzieht, wobei das Strahlmittel vorzugsweise eine geringere Härte als Korund ($\alpha$-Al$_2$O$_3$) aufweist.

3. Schneideinsatz nach einem der vorangegangenen Ansprüche, **dadurch gekennzeichnet, dass** die über der Substratoberfläche und unter der $\alpha$-Al$_2$O$_3$-Lage angeordneten Hartstofflagen und die optional über der $\alpha$-Al$_2$O$_3$-Lage wenigstens abschnittsweise angeordneten Hartstofflagen aus Carbiden, Nitriden, Oxiden, Carbonitriden, Oxinitriden, Oxicarbiden, Oxicarbonitriden, Boriden, Boronitriden, Borocarbiden, Borocarbonitriden, Borooxinitriden, Borooxocarbiden, Borooxocarbonitriden der Elemente der Gruppen IVa bis VIIa des Periodensystems und/oder des Aluminiums und/oder gemischtmetallischen Phasen und/oder Phasengemischen der vorgenannten Verbindungen bestehen.

4. Schneideinsatz nach einem der vorangegangenen Ansprüche, **dadurch gekennzeichnet, dass** die über der Substratoberfläche und unter der $\alpha$-Al$_2$O$_3$-Lage angeordneten Hartstofflagen aus TiN, TiCN und/oder TiAlCNO bestehen und die Lagen jeweils Schichtdicken im Bereich von 0,1 $\mu$m bis 15 $\mu$m aufweisen, wobei eine Hartstofflage aus TiAlCNO, wenn diese vorhanden ist und unmittelbar unter der $\alpha$-Al$_2$O$_3$-Lage angeordnet ist, vorzugsweise eine Schichtdicke im Bereich von 0,1 $\mu$m bis 1 $\mu$m aufweist und wobei eine Hartstofflage aus TiN oder TiCN, wenn diese vorhanden ist, vorzugsweise eine Schichtdicke im Bereich von 2 $\mu$m bis 15 $\mu$m, besonders bevorzugt im Bereich von 3 $\mu$m bis 10 $\mu$m aufweist.

5. Schneideinsatz nach einem der vorangegangenen Ansprüche, **dadurch gekennzeichnet, dass** die über der Substratoberfläche und unter der $\alpha$-Al$_2$O$_3$-Lage angeordneten Hartstofflagen Lagen aus TiN, TiCN und/oder TiAlCNO zusammen eine Gesamtschichtdicke im Bereich von 3 $\mu$m bis 16 $\mu$m, vorzugsweise im Bereich von 5 $\mu$m bis 12 $\mu$m, besonders bevorzugt im Bereich von 7 $\mu$m bis 11 $\mu$m aufweisen.

6. Schneideinsatz nach einem der vorangegangenen Ansprüche, **dadurch gekennzeichnet, dass** die mehrlagige Beschichtung ausgehend von der Substratoberfläche folgende Lagenabfolge aufweist: TiN - TiCN - TiAlCNO - $\alpha$-Al$_2$O$_3$, wobei optional wenigstens abschnittsweise über der $\alpha$-Al$_2$O$_3$-Lage eine TiN-Lage, eine TiCN-Lage, eine TiC-Lage oder eine Kombination daraus vorgesehen sind.

7. Schneideinsatz nach einem der vorangegangenen Ansprüche, **dadurch gekennzeichnet, dass** der Substratkörper innerhalb eines Bereichs vom äußersten Oberflächenbereich bis zu einer Tiefe von 10 $\mu$m von der äußersten Oberfläche des Substratkörpers ein Eigenspannungs-Minimum von wenigstens -400 MPa, vorzugsweise von wenigstens-600 MPa, besonders bevorzugt von wenigstens -800 MPa aufweist.

8. Schneideinsatz nach einem der vorangegangenen Ansprüche, **dadurch gekennzeichnet, dass** der Substratkörper aus Hartmetall besteht, vorzugsweise enthaltend 4 bis 12 Gew.-% Co, Fe und/oder Ni, vorzugsweise Co, optional 0,5 bis 10 Gew.-% kubische Carbide der Metalle der Gruppen IVb, Vb und VIb des Periodensystems, vorzugsweise Ti, Nb, Ta oder Kombinationen davon, und als Rest WC.

9. Schneideinsatz nach einem der vorangegangenen Ansprüche, **dadurch gekennzeichnet, dass** der Substratkörper aus Hartmetall besteht und eine gegenüber der nominellen Gesamtzusammensetzung des Substratkörpers mit Co-Binderphase angereicherte und von kubischen Carbiden abgereicherte Oberflächenzone aufweist, die ausgehend von der Substratoberfläche eine Dicke von 5 $\mu$m bis 30 $\mu$m, vorzugsweise von 10 $\mu$m bis 25 $\mu$m besitzt, wobei der Gehalt an Co in der mit Co-Binderphase angereicherten Oberflächenzone wenigstens 1,5-mal höher ist als im Kern des Substrats und der Gehalt an kubischen Carbiden in der mit Co-Binderphase angereicherten Oberflächenzone höchstens das 0,5-fache des Gehalts an kubischen Carbiden im Kern des Substrats beträgt.

10. Verfahren zur Herstellung eines Schneideinsatzes nach einem der vorangegangenen Ansprüche, bei dem man auf einen Substratkörper aus Hartmetall-, Cermet-, oder Keramik mittels CVD-Verfahren eine mehrlagige Beschichtung mit einer Gesamtschichtdicke von 5 bis 40 $\mu$m aufbringt, welche ausgehend von der Substratoberfläche eine oder mehrere Hartstofflagen, über den Hartstofflagen eine alpha-Aluminiumoxid ($\alpha$-Al$_2$O$_3$) - Lage mit einer Lagendicke von 1 bis 20 $\mu$m und optional wenigstens abschnittsweise über der $\alpha$-Al$_2$O$_3$-Lage eine oder mehrere weitere Hartstofflagen als Dekor- oder Verschleißerkennungslagen aufweist, wobei die Abscheidungsbedingungen für die $\alpha$-Al$_2$O$_3$-Lage so gewählt werden, dass die $\alpha$-Al$_2$O$_3$-Lage eine kristallographische Vorzugsorientierung aufweist, charakterisiert durch einen Texturkoeffizienten TC (0 0 12) $\geq$ 5 für die (0 0 12) Wachstumsrichtung mit

$$TC(0\ 0\ 12) = \frac{I(0\ 0\ 12)}{I_0(0\ 0\ 12)} \left[ \frac{1}{n} \sum_{n=1}^{n} \frac{I(hkl)}{I_0(hkl)} \right]^{-1},$$

wobei

I(hkl) die durch Röntgenbeugung gemessenen Intensitäten der Beugungsreflexe sind,

$I_0$(hkl) die Standardintensitäten der Beugungsreflexe nach pdf-Karte 42-1468 sind,
n die Anzahl der für die Berechnung verwendeten Reflexe ist und
für die Berechnung von TC(0 0 12) folgende Reflexe verwendet werden:

(0 1 2), (1 0 4), (1 1 0), (1 1 3), (1 1 6), (3 0 0) und (0 0 12), welche gemäß pdf-Karte 42-1468 folgende Standardintensitäten $I_0$(hkl) besitzen:

| Reflex (h k l): | Standardintensität $I_0$(hkl): |
|---|---|
| (0 1 2) | 70 |
| (1 0 4) | 97 |
| (1 1 0) | 42 |
| (1 1 3) | 100 |
| (1 1 6) | 82 |
| (3 0 0) | 45 |
| (0 0 12) | 2 |

und man das Substrat nach dem Aufbringen der mehrlagigen Beschichtung einer Trocken- oder Nassstrahlbehandlung, vorzugsweise einer Trockenstrahlbehandlung, unter Verwendung eines körnigen Strahlmittels unterzieht, wobei das Strahlmittel vorzugsweise eine geringere Härte als Korund ($\alpha$-Al$_2$O$_3$) aufweist und wobei man den Strahldruck, die Strahldauer und den Strahlwinkel der Strahlbehandlung so auswählt, dass die $\alpha$-Al$_2$O$_3$-Lage nach der Strahlbehandlung eine Eigenspannung im Bereich von 0 bis +300 MPa aufweist und das Substrat nach der Strahlbehandlung innerhalb eines Bereichs von 0 bis 10 $\mu$m von der Substratoberfläche ein Eigenspannungs-Minimum im Bereich von -2000 bis -400 MPa aufweist.

## Claims

1. A cutting insert made of a hard metal, cermet or ceramic substrate body and a multilayer coating which is applied thereto by means of CVD methods of a total thickness of 5 to 40 $\mu$m and which starting from the substrate surface has one or more hard material layers, over the hard material layers an alpha aluminium oxide ($\alpha$-Al$_2$O$_3$) layer of a layer thickness of 1 to 20 $\mu$m and optionally at least portion-wise over the $\alpha$-Al$_2$O$_3$ layer one or more further hard material layers as decorative or wear recognition layers, **characterised in that** the $\alpha$-Al$_2$O$_3$ layer has a crystallographic preferential orientation, **characterised by** a texture coefficient TC (0 0 12) $\geq 5$ for the (0 0 12) growth direction with

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

wherein

I(hkl) are the intensities of the diffraction reflections measured by X-ray diffraction,
$I_0$(hkl) are the standard intensities of the diffraction reflections in accordance with pdf card 42-1468,
n is the number of reflections used for the calculation, and
the following reflections are used for the calculation of TC(0 0 12):

(0 1 2), (1 0 4), (1 1 0), (1 1 3), (1 1 6), (3 0 0) and (0 0 12), which, according to pdf card 42-1468 have the following standard intensities $I_0$(hkl):

| Reflex ( h k l): | Standard intensity $I_0$(hkl): |
|---|---|
| (0 1 2) | 70 |

(continued)

| Reflex ( h k l): | Standard intensity $I_0$(hkl): |
|---|---|
| (1 0 4) | 97 |
| (1 1 0) | 42 |
| (1 1 3) | 100 |
| (1 1 6) | 82 |
| (3 0 0) | 45 |
| (0 0 12) | 2 |

and wherein the $\alpha$-Al$_2$O$_3$ layer has a residual stress in the region of 0 to +300 MPas, and the substrate within a region of 0 to 10 $\mu$m from the substrate surface has a residual stress minimum in the region of -2000 to -400 MPas.

2. A cutting insert according to claim 1 **characterised in that** the production of the cutting insert includes the substrate being subjected to a dry or wet blasting treatment, preferably a dry blasting treatment, using a granular blasting agent, after application of the multi-layer coating, wherein the blasting agent preferably has a lower level of hardness than corundum ($\alpha$-Al$_2$O$_3$).

3. A cutting insert according to one of the preceding claims **characterised in that** the hard material layers arranged over the substrate surface and under the $\alpha$-Al$_2$O$_3$ layer and the hard material layers arranged at least portion-wise optionally over the $\alpha$-Al$_2$O$_3$ layer consist of carbides, nitrides, oxides, carbonitrides, oxynitrides, oxycarbides, oxycarbonitrides, borides, boronitrides, borocarbides, borocarbonitrides, borooxynitrides, borooxocarbides or borooxocarbonitrides of the elements of groups IVa to VIIa of the periodic system and/or aluminium and/or mixed metal phases and/or phase mixtures of the afore-mentioned compounds.

4. A cutting insert according to one of the preceding claims **characterised in that** the hard material layers arranged over the substrate surface and under the $\alpha$-Al$_2$O$_3$ layer consist of TiN, TiCN and/or TiAlCNO, wherein the hard material layers respectively have layer thicknesses in the region of 0.1 $\mu$m to 15 $\mu$m, wherein a hard material layer of TiAlCNO, if same is present and is arranged directly under the $\alpha$-Al$_2$O$_3$ layer, is preferably of a layer thickness in the region of 0.1 $\mu$m to 1 $\mu$m, and wherein a hard material layer of TiN or TiCN, if same is present, is preferably of a layer thickness in the region of 2 $\mu$m to 15 $\mu$m, particularly preferably in the region of 3 $\mu$m to 10 $\mu$m.

5. A cutting insert according to one of the preceding claims **characterised in that** the hard material layers arranged over the substrate surface and under the $\alpha$-Al$_2$O$_3$ layer and comprising TiN, TiCN and/or TiAlCNO are together of a total layer thickness in the region of 3 $\mu$m to 16 $\mu$m, preferably in the region of 5 $\mu$m to 12 $\mu$m, particularly preferably in the region of 7 $\mu$m to 11 $\mu$m.

6. A cutting insert according to one of the preceding claims **characterised in that** the multilayer coating, starting from the substrate surface, has the following layer succession: TiN - TiCN - TiAlCNO - $\alpha$-Al$_2$O$_3$, wherein optionally a TiN layer, a TiCN layer, a TiC layer or a combination thereof are provided at least portion-wise over the $\alpha$-Al$_2$O$_3$ layer.

7. A cutting insert according to one of the preceding claims **characterised in that** within a region from the outermost surface region to a depth of 10 $\mu$m from the outermost surface of the substrate body the substrate body has a residual stress minimum of at least -400 MPas, preferably at least -600 MPas, particularly preferably at least -800 MPas.

8. A cutting insert according to one of the preceding claims **characterised in that** the substrate body comprises hard metal, preferably containing 4 to 12% by weight of Co, Fe and/or Ni, preferably Co, optionally 0.5 to 10% by weight of cubic carbides of the metals of groups IVb, Vb and VIb of the periodic system, preferably Ti, Nb, Ta or combinations thereof, and WC as the balance.

9. A cutting insert according to one of the preceding claims **characterised in that** the substrate body consist of hard metal and has a surface zone which is enriched with Co binder phase in relation to the nominal overall composition of the substrate body and which is depleted of cubic carbides and which starting from the substrate surface is of a

thickness of 5 $\mu$m to 30 $\mu$m, preferably 10 $\mu$m to 25 $\mu$m, wherein the content of Co in the surface zone enriched with Co binder phase is at least 1.5 times higher than in the core of the substrate and the content of cubic carbides in the surface zone enriched with Co binder phase is at most 0.5 times the content of cubic carbides in the core of the substrate.

**10.** A method for production of a cutting insert according to one of the preceding claims in which there is applied to a substrate body of hard metal, cermet or ceramic by means of CVD methods a multi-layer coating which is of a total thickness of 5 to 40 $\mu$m and which starting from the substrate surface has one or more hard material layers, over the hard material layers an alpha aluminium oxide ($\alpha$-Al$_2$O$_3$) layer of a layer thickness of 1 to 20 $\mu$m and optionally at least portion-wise over the $\alpha$-Al$_2$O$_3$ layer one or more further hard material layers as decorative or wear recognition layers wherein the deposition conditions for the $\alpha$-Al$_2$O$_3$ layer are so selected that the $\alpha$-Al$_2$O$_3$ layer has a crystallographic preferential orientation, **characterised by** a texture coefficient TC (0 0 12) $\geq$ 5 for the (0 0 12) growth direction with

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

wherein

I(hkl) are the intensities of the diffraction reflections measured by X-ray diffraction,
I$_0$(hkl) are the standard intensities of the diffraction reflections in accordance with pdf card 42-1468,
n is the number of reflections used for the calculation, and
the following reflections are used for the calculation of TC(0 0 12):

(0 1 2), (1 0 4), (1 1 0), (1 1 3), (1 1 6), (3 0 0) and (0 0 12), which, according to pdf card 42-1468 have the following standard intensities I$_0$(hkl):

| Reflex (h k l): | Standard intensity I$_0$(hkl): |
|---|---|
| (0 1 2) | 70 |
| (1 0 4) | 97 |
| (1 1 0) | 42 |
| (1 1 3) | 100 |
| (1 1 6) | 82 |
| (3 0 0) | 45 |
| (0 0 12) | 2 |

and after application of the multi-layer coating the substrate is subjected to a dry or wet blasting treatment, preferably a dry blasting treatment, using a granular blasting agent, wherein the blasting agent is preferably of a lower hardness than corundum ($\alpha$-Al$_2$O$_3$) and wherein the blasting pressure, the blasting duration and the blasting angle of the blasting treatment are so selected that after the blasting treatment the $\alpha$-Al$_2$O$_3$ layer has a residual stress in the region of 0 to +300 MPas, and the substrate after the blasting treatment within a region of 0 to 10 $\mu$m from the substrate surface has a residual stress minimum in the region of -2000 to -400 MPas.

## Revendications

**1.** Dispositif de coupe constitué d'un corps de substrat en métal dur, cermet ou céramique, et d'un revêtement multicouche qui est déposé sur ce dernier par un procédé de dépôt chimique en phase vapeur, ayant une épaisseur totale de couche de 5 à 40 $\mu$m, qui, en partant de la surface du substrat, comprend une ou plusieurs couches de matériau dur, par-dessus les couches de matériau dur une couche d'oxyde d'aluminium alpha ($\alpha$-Al$_2$O$_3$) ayant une épaisseur de couche de 1 à 20 $\mu$m, et en option, au moins sur certaines parties de la couche d'$\alpha$-Al$_2$O$_3$, une ou

plusieurs couches de matériau dur servant de couches de décoration ou de détection d'usure, **caractérisé en ce que** la couche d'$\alpha$-Al$_2$O$_3$ présente une orientation préférentielle cristallographique, **caractérisée par** un coefficient de texture TC (0 0 12) $\geq$ 5 pour la direction de croissance (0 0 12), avec

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

où

I(hkl) désigne les intensités des réflexions de diffraction, mesurées par diffraction aux rayons X,
I$_0$(hkl) représente les intensités étalons des réflexions de diffraction d'après la carte pdf 42-1468,
n est le nombre de réflexions utilisées pour le calcul, et
on utilise pour le calcul de TC (0 0 12) les réflexions suivantes :

(0 1 2), (1 0 4), (1 1 0), (1 1 3), (1 1 6), (3 0 0) et (0 0 12), qui selon la carte pdf 42-1468 présentent les intensités étalons I$_0$(hkl) suivantes :

| Réflexion (h k l) | Intensité étalon I$_0$(hkl) |
|---|---|
| (0 1 2) | 70 |
| (1 0 4) | 97 |
| (1 1 0) | 42 |
| (1 1 3) | 100 |
| (1 1 6) | 82 |
| (3 0 0) | 45 |
| (0 0 12) | 2 |

et où la couche d'$\alpha$-Al$_2$O$_3$ présente une contrainte résiduelle comprise dans la plage de 0 à +300 MPa, et le substrat présente, dans un domaine de 0 à 10 $\mu$m à partir de la surface du substrat, un minimum de contrainte résiduelle compris dans la plage de -2000 à -400 MPa.

2. Dispositif de coupe selon la revendication 1, **caractérisé en ce que** la fabrication du dispositif de coupe comprend l'opération selon laquelle, en utilisant un agent de sablage granulaire, on soumet le substrat, après application du revêtement multicouche, à un traitement de sablage à sec ou par voie humide, de préférence à un traitement de sablage à sec, l'agent de sablage présentant de préférence une dureté inférieure à celle du corindon ($\alpha$-Al$_2$O$_3$).

3. Dispositif de coupe selon l'une des revendications précédentes, **caractérisé en ce que** les couches de matériau dur disposées par-dessus la surface du substrat et en-dessous de la couche d'$\alpha$-Al$_2$O$_3$, et les couches de matériau dur qui sont en option disposées au moins sur certaines parties par-dessus la couche d'$\alpha$-Al$_2$O$_3$, sont constituées de carbures, de nitrures, d'oxydes, de carbonitrures, d'oxynitrures, d'oxycarbures, d'oxycarbonitrures, de borures, de boronitrures, de borocarbures, de borocarbonitrures, de borooxynitrures, de borooxocarbures, de borooxocarbonitrures des éléments des Groupes IVa à VIIa de la classification périodique des éléments et/ou d'aluminium et/ou de phases métalliques mixtes et/ou de mélanges de phases des composés précités.

4. Dispositif de coupe selon l'une des revendications précédentes, **caractérisé en ce que** les couches de matériau dur disposées par-dessus la surface du substrat et en-dessous de la couche d'$\alpha$-Al$_2$O$_3$ sont constituées de TiN, de TiCN et/ou de TiAlCNO, et chaque couche présente une épaisseur de couche comprise dans la plage de 0,1 $\mu$m à 15 $\mu$m, une couche de matériau dur en TiAlCNO, quand cette dernière est présente et est disposée immédiatement en-dessous de la couche d'$\alpha$-Al$_2$O$_3$, présentant de préférence une épaisseur de couche comprise dans la plage de 0,1 $\mu$m à 1 $\mu$m, et une couche de matériau dur en TiN ou TiCN, quand celle-ci est présente, présentant de préférence une épaisseur de couche comprise dans la plage de 2 $\mu$m à 15 $\mu$m, d'une manière particulièrement préférée dans la plage de 3 $\mu$m à 10 $\mu$m.

**5.** Dispositif de coupe selon l'une des revendications précédentes, **caractérisé en ce que** les couches de matériau dur en TiN, TiCN et/ou TiAlCNO, disposées par-dessus la surface du substrat et en-dessous de la couche d'$\alpha$-$Al_2O_3$, présentent une épaisseur totale de couche comprise dans la plage de 3 $\mu$m à 16 $\mu$m, de préférence dans la plage de 5 $\mu$m à 12 $\mu$m, d'une manière particulièrement préférée dans la plage de 7 $\mu$m à 11 $\mu$m.

**6.** Dispositif de coupe selon l'une des revendications précédentes, **caractérisé en ce que** le revêtement multicouche présente, en partant de la surface du substrat, la séquence de couches suivante : TiN - TiCN-TiAlCNO - $\alpha$-$Al_2O_3$, une couche de TiN, une couche de TiCN, une couche de TiC ou une combinaison de celles-ci étant prévue(s) en option au moins sur certaines parties par-dessus la couche d'$\alpha$-$Al_2O_3$.

**7.** Dispositif de coupe selon l'une des revendications précédentes, **caractérisé en ce que** le corps de substrat présente, dans une zone allant de la zone superficielle la plus extérieure jusqu'à une profondeur de 10 $\mu$m à partir de la surface la plus extérieure du corps de substrat, un minimum de contrainte résiduelle d'au moins -400 MPa, de préférence d'au moins -600 MPa, d'une manière particulièrement préférée d'au moins -800 MPa.

**8.** Dispositif de coupe selon l'une des revendications précédentes, **caractérisé en ce que** le corps de substrat est constitué de métal dur, contenant de préférence 4 à 12 % en poids de Co, de Fe et/ou de Ni, de préférence de Co, en option 0,5 à 10 % en poids de carbures cubiques des métaux des Groupes IVb, Vb et VIb de la classification périodique des éléments, de préférence de Ti, de Nb, de Ta ou de combinaisons de ceux-ci, le reste étant constitué de WC.

**9.** Dispositif de coupe selon l'une des revendications précédentes, **caractérisé en ce que** le corps de substrat est constitué de métal dur, et présente une zone superficielle enrichie en phase liante de Co et appauvrie en carbures cubiques par rapport à la composition totale nominale du corps de substrat, zone qui, en partant de la surface du substrat, présente une épaisseur de 5 $\mu$m à 30 $\mu$m, de préférence de 10 $\mu$m à 25 $\mu$m, la teneur en Co de la zone superficielle enrichie en phase liante de Co étant au moins 1,5 fois plus grande que dans le coeur du substrat, et la teneur en carbures cubiques de la zone superficielle enrichie en phase liante de Co étant d'au plus 0,5 fois la teneur en carbures cubiques du coeur du substrat.

**10.** Procédé de fabrication d'un dispositif de coupe selon l'une des revendications précédentes, dans lequel on applique sur un corps de substrat en métal dur, en cermet ou en céramique, par un procédé de dépôt chimique en phase vapeur, un revêtement multicouche ayant une épaisseur totale de couche de 5 à 40 $\mu$m, qui à partir de la surface du substrat comprend une ou plusieurs couches d'un matériau dur, par-dessus les couches de matériau dur une couche d'oxyde d'aluminium alpha ($\alpha$-$Al_2O_3$) ayant une épaisseur de couche de 1 à 20 $\mu$m, et en option, sur au moins certaines parties au-dessus de la couche d'$\alpha$-$Al_2O_3$, une ou plusieurs couches de matériau dur supplémentaires servant de couches de décoration ou de détection d'usure, les conditions de dépôt de la couche d'$\alpha$-$Al_2O_3$ étant choisies de telle sorte que la couche d'$\alpha$-$Al_2O_3$ présente une orientation préférentielle cristallographique, **caractérisée par** un coefficient de texture TC (0 0 12) $\geq$ 5 pour la direction de croissance (0 0 12), avec

$$TC(0\ 0\ 12) = \frac{I(0\ 0\ 12)}{I_0(0\ 0\ 12)}\left[\frac{1}{n}\sum_{n=1}^{n}\frac{I(hkl)}{I_0(hkl)}\right]^{-1},$$

où

I(hkl) désigne les intensités des réflexions de diffraction, mesurées par diffraction aux rayons X,
$I_0$(hkl) représente les intensités étalons des réflexions de diffraction d'après la carte pdf 42-1468,
n est le nombre de réflexions utilisées pour le calcul, et
on utilise pour le calcul de TC (0 0 12) les réflexions suivantes :

(0 1 2), (1 0 4), (1 1 0), (1 1 3), (1 1 6), (3 0 0) et (0 0 12), qui selon la carte pdf 42-1468 présentent les intensités étalons $I_0$(hkl) suivantes :

| Réflexion (h k l) | Intensité étalon $I_0$(hkl) |
|---|---|
| (0 1 2) | 70 |

(suite)

| Réflexion (h k l) | Intensité étalon $I_0(hkl)$ |
|---|---|
| (1 0 4) | 97 |
| (1 1 0) | 42 |
| (1 1 3) | 100 |
| (1 1 6) | 82 |
| (3 0 0) | 45 |
| (0 0 12) | 2 |

et on soumet le substrat, après application du revêtement multicouche, à un traitement de sablage à sec ou par voie humide, de préférence à un traitement de sablage à sec, en utilisant un agent de sablage granulaire, l'agent de sablage présentant de préférence une dureté plus faible que celle du corindon ($\alpha$-$Al_2O_3$), et la pression de sablage, la durée du sablage et l'angle de sablage du traitement de sablage étant choisis de telle sorte que la couche d'$\alpha$-$Al_2O_3$ présente après le traitement de sablage une contrainte résiduelle comprise dans la plage de 0 à +300 MPa, et que le substrat, après le traitement de sablage, présente, dans une zone de 0 à 10 $\mu$m à partir de la surface du substrat, un minimum de contrainte résiduelle compris dans la plage de -2000 à -400 MPa.

EP 2 756 110 B1

_**Fig. 1**_

(Stand der Technik)

_**Fig. 2**_

(Erfindung)

25

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19719195 A
- DE 10123554 A
- WO 2009101025 A
- US 20070104945 A
- EP 1953258 A
- EP 2014789 A

**In der Beschreibung aufgeführte Nicht-Patentliteratur**

- **V. HAUK.** Structural and Residual Stress Analysis by Nondestructive Methods. Elsevier, 1997
- **E. MACHERAUCH ; P. MÜLLER.** *Z. angew. Physik,* 1961, vol. 13, 305
- Diffraction Analysis of the Microstructure of Materials. Springer Series in Material Science. 2004, vol. 68, 473
- **CH. GENZEL.** *Mat. Science and Technol.,* 2005, vol. 21, 10
- **CH. GENZEL.** *Adv. X-Ray Analysis,* 2001, vol. 44, 247
- **C. STOCK.** *Promotionsarbeit,* 2003
- **CH. GENZEL ; C. STROCK ; W. REIMERS.** *Mat. Sci. Eng.,* 2004, vol. A 372, 28
- **CH. GENZEL ; I. A. DENKS ; M. KLAUS.** *Mat. Sci. Forum,* 2006, vol. 524-525, 193
- Landoldt-Börnstein, New Series, Group III. Springer, 1979, vol. 11
- **W. KRESS ; P. ROEDHAMMER ; H. BILZ ; W. TEUCHERT ; A. N. CHRISTENSEN.** *Phys. Rev.,* 1978, vol. B17, 111
- **J. D. ESHELBY.** *Proc. Roy. Soc. (London),* 1957, vol. A241, 376
- **E. KRÖNER.** *Z. Physik,* 1958, vol. 151, 504